# EUROPEAN PATENT APPLICATION

(11) **EP 2 059 089 A2**
(43) Date of publication of application: **13.05.2009**
(21) Application number: 08019272.7
(22) Date of filing: 04.11.2008
(51) Int. Cl.: H05B 3/00

(54) **Light irradiation type heat treatment device**

(30) Priority: 06.11.2007 JP 2007288431
(71) Applicant: Ushiodenki Kabushiki Kaisha, Chiyoda-ku 100 Tokyo (JP)
(72) Inventor: Suzuki, Shinji, Tokyo-to (JP); Seki, Kyohei, Hyogo-ken (JP)
(74) Representative: Tomerius, Isabel

(57) **Abstract**

Light irradiation type heat treatment device composed of a plurality of lamps, including multi-filament lamps, the filaments of which can be independently supplied with power. The filaments are divided into a plurality of filament groups composed of filaments of one lamp put together with filaments of other lamps. Power control units are provided for each group, and drive units are provided corresponding to the power control units. The drive units adjust the electric power supplied from the power supply according to a command from the power control units to supply power to each filament belonging to the group. In a preferred arrangement, the plurality of lamps are arranged in parallel with at least one filament within each lamp having a length so as to form a concentric circle with filaments of other lamps arranged in parallel and the filaments forming the concentric circle are divided into a plurality of filament groups.

## Description

### Background of the Invention

### Field of Invention

The present invention relates to a light irradiation type heat treatment device that heats a workpiece rapidly to a high temperature by irradiation with light.

### Description of Related Art

The light irradiation heat treatment in a semiconductor production process is conducted in a broad range, such as film formation, diffusion or annealing. Any treatment is to apply a heat treatment to a semiconductor wafer (hereafter, simply referred to as 'wafer'), which is a plate-like workpiece. If light irradiation heat treatment is used for this heat treatment, a wafer can be rapidly heated or cooled down. For example, it is possible to heat the wafer to 1000 °C or higher in several seconds to several tens of seconds after light irradiation of the wafer is started. If the light irradiation is stopped, the wafer can be cooled down rapidly.

For the light irradiation type heat treatment device, as a heat source, a plurality of incandescent lamps is used in general. Incandescent lamps where filaments are arranged inside a light tube made of an optically-transparent material is suitable for a rapid heat treatment of a workpiece because its rise time of light output is fast. Particularly, in the case of a halogen lamp, due to the effect of a cyclic regeneration reaction (halogen cycle) with halogen encapsulated within a light tube (bulb) and a tungsten filament that is evaporated by heating, it has the advantage that even if the bulb is miniaturized, it will not be blackened and its lifetime is also prolonged.

Herein, in the case that the material of the wafer is silicon, on the occasion that the wafer is heated to 1050 °C or higher, if unevenness of temperature distribution occurs in the wafer, a phenomenon referred to as a slip, i.e., a defect of crystal transition, occurs in the wafer. As a result, the heat treated wafer will be defective. Then, in the case that the wafer is heat treated using a light irradiation heat treatment device, it is necessary to heat, maintain at higher temperature and cool down so as to make the temperature distribution of the entire wafer surface uniform. Further, this similarly applies even in the case of heating a wafer for film formation. In other words, in order to form a film on a wafer surface with a uniform thickness, the wafer has to be heated so as to make the temperature distribution of the wafer uniform.

In the case that the physical characteristics of the entire wafer surface are uniform, if light is irradiated so as to unify the irradiance on the entire wafer surface, it appears that the wafer temperature becomes uniform. However, in actuality, even if light is radiated onto the wafer under this irradiation condition, the temperature around the periphery of the wafer becomes low and unevenness of the temperature distribution occurs in the wafer. As described above, in the case of heating a wafer to 1050 °C or higher, if the unevenness of the temperature distribution occurs in the wafer, slip occurs.

As described above, the reason why the temperature around the wafer periphery is low is because heat is radiated from the wafer periphery, such as from the wafer side or from the vicinity of the wafer side face. Therefore, in order to unify the temperature distribution throughout the wafer, it is necessary to compensate the temperature reduction due to heat radiation from the wafer edge. For example, light is irradiated so as to make the irradiance on the surface around the wafer periphery greater than that on the surface in the center of the wafer.

Recently, as one of methods of preventing the temperature reduction around the wafer periphery, a method of arranging an auxiliary material with the same heat capacity as a wafer so as to surround an outer circumference of the wafer has been proposed. This auxiliary material is generally referred to as a guard ring. In the case that the heat capacity of the guard ring arranged so as to surround the outer circumference of the wafer is the same level as that of the wafer, it becomes possible that the wafer and the guard ring are regarded as one integrated virtual plate body. In this case, since the periphery of the wafer will never be a periphery of the virtual plate body, no heat irradiation from the periphery of the wafer will occur. Consequently, the temperature of the wafer periphery will not decrease. In other words, it becomes possible to compensate the temperature reduction due to the heat radiation from the wafer periphery and to unify the wafer temperature by using the above-mentioned guard ring.

Furthermore, since the guard ring is established so as to surround the outer circumference of the wafer, a mechanism to retain the wafer periphery is added to the guard ring and the guard ring is often used as a wafer carrier. However, in actuality, it is difficult to produce a guard ring so as to regard this as an integration with a wafer (in other words, so as to adjust the heat capacity to be the same). The reason will be described below.
(a) In order to equalize the heat capacity of the guard ring with that of the wafer, the same material as that of the wafer should be used for the guard ring. For example, in the case that the wafer is a silicon wafer, the material of the guard ring should be silicon (Si). However, if silicon is repeatedly exposed to a great difference in temperature, it deforms and such guard ring will no longer function as a guard ring.
(b) In order to avoid the deformation problem, in general, the guard is often made of silicon carbide (SiC). Although silicon carbide has a slightly greater specific heat capacity than silicon, the difference is not so great. However, it is difficult to process silicon carbide, and because the thickness cannot be lower than 1 mm due to a processing problem (yield), it will be thicker than the thickness of wafer, which is 0.7 to 0.8 mm thick. Due to the difference in the specific heat capacity between silicon and silicon carbide and the difference in the wafer thickness and the thickness of the guard ring made of silicon carbide, the heat capacity of the guard ring becomes approximately 1.5 times greater compared to the wafer per unit area when it is heated to a high temperature.

Therefore, in order to cause the guard ring to function so as to compensate for the temperature reduction around the wafer periphery, it is necessary to eliminate the effect of the difference in the heat capacity between the wafer and the guard ring. Specifically, it is necessary to irradiate light so as to make the irradiance on the guard ring greater than the irradiance on the wafer.

As described above, areas where heating and cooling characteristics are different exist in the workpiece. For example, in the case that the workpiece is a wafer, the heat radiation from the wafer periphery affects the wafer center area and the wafer peripheral area, and the heating and cooling characteristics in both areas are different from each other. Therefore, when it is presumed that the physical characteristics of the entire wafer surface are uniform, even if light is irradiated so as to make the irradiance on the entire wafer surface uniform, the wafer temperature will not be uniform.

Consequently, while the temperature distribution is uniformly maintained throughout the entire wafer surface, if a light irradiation heat treatment is applied to the wafer, it is necessary to adjust the irradiance in areas where the heating and cooling characteristics on the wafer surface are different from each other, respectively. This similarly applies to the case of using a guard ring so as to compensate the temperature reduction around the periphery of the workpiece (wafer), as well. In the case of using the guard ring, it is necessary to irradiate light with greater irradiance to the guard ring area than to the wafer area by taking the difference in the heat capacity between the wafer and the guard ring into consideration. In other words, in the light irradiation heat treatment of a workpiece, taking the heating/cooling characteristics of the workpiece into consideration, it is necessary to divide the surface of the workpiece (including a guard ring surface in the case of using the guard ring) into a plurality of zones and to irradiate light to each zone with different light intensity.

According to the above-mentioned circumstances, a function to optionally set the distribution of the illuminance on the workpiece in each zone and to thus irradiate light becomes essential to the heat treatment device of the light irradiation type. It becomes possible to apply the light irradiation heat treatment to a workpiece while the temperature distribution is uniformly maintained throughout the entire surface of the workpiece by using a heat treatment device of the light irradiation type having this function. Hereafter, a heat treatment device of the light irradiation type having the function will be described.

In the above-mentioned heat treatment device of the light irradiation type, a heat source is composed of a plurality of incandescent lamps. Then, the illuminance distribution in the irradiation area is set to a predetermined distribution by controlling the plurality of lamps by dividing them into several control zones (lamp groups). For example, in the heat treatment device of the light irradiation type described in JP S62-20308 A, a light source, which is a heating means, is configured such that a plurality of straight tube halogen lamps is aligned in parallel. These halogen lamps are divided into lamp groups including several lamps, and the heat output from each lamp group is independently controlled by regarding each lamp group as a control unit. Specifically, first, temperatures at a plurality of points in the workpiece are detected by a radiation thermometer. Then, based upon the detection results, the aforementioned control unit is controlled so as to unify the temperature of the workpiece.

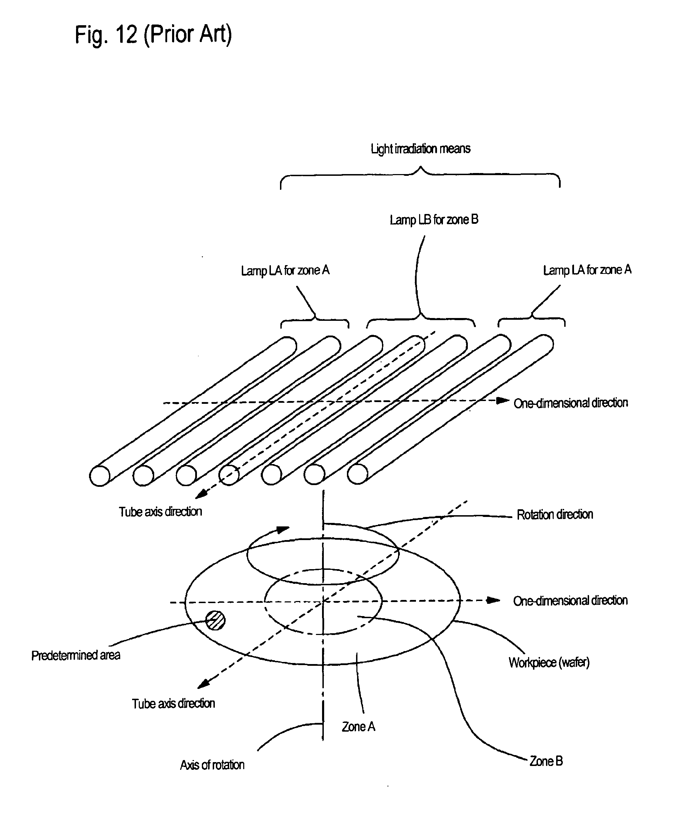

Furthermore, in the heat treatment device of the light irradiation type described in JP S62-20308 A, the light source is configured by a plurality of straight pipe halogen lamps arranged in parallel. Consequently, the control of irradiating light with different light intensity to each zone on the workpiece (hereafter, referred to as 'zone control', as well) is applied only in the one-dimensional direction perpendicular to the tube axis direction of the straight tube lamp. For example, as shown in Fig. 12, the case of dividing the irradiation area of the workpiece W into a zone B in the center part of the workpiece and a zone A in the periphery of the workpiece is considered.

According to each zone, the straight tube halogen lamps composing the light source are also divided into a lamp group LA for zone A and a lamp group LB for zone B. In this case, each lamp group can correspond to each zone in the one-dimensional direction shown in Fig. 12. For example, it becomes possible to make the irradiance in the zone A greater than that in the zone B by setting the light intensity of light to be emitted from the lamp group LA for zone A greater than that of light to be emitted from the lamp group LB for zone B.

Here, for the tube axis direction of a straight tube lamp (a direction perpendicular to the one-dimensional direction in Fig. 12), since one lamp corresponds to both zones, it is impossible to implement zone control. Therefore, normally, in order to apply the zone control to the entire surface of the workpiece (in other words, the two-dimensional direction), the workpiece W is often rotated during the light irradiation. In other words, in the case of heating the workpiece using the heat treatment device of the light irradiation type described in JP S62-20308 A, the zones set on the workpiece are divided in a concentric fashion.

Herein, in the case of rotating the workpiece W, for example, in a predetermined position of the zone A, the period when light of the lamp group LB for zone B is mainly irradiated comes along periodically due to the rotation of the workpiece W, in between the period when light from the lamp group LA for zone A is mainly irradiated. In other words, a pulsating state of the irradiance is averaged throughout the zone A. Therefore, the workpiece is rotated, and the irradiance is averaged and the two-dimensional zone control is effectively performed; however, the soaking accuracy of the workpiece itself is low. Depending upon circumstances, repetition of a high illuminance period and a low illuminance period may cause the generation of deformation in the workpiece.

Recently, a heat treatment device of the light irradiation type having a function to optionally set an illuminance distribution in each zone on the workpiece W without rotating the workpiece was proposed by the inventors. The heat treatment device of the light irradiation type uses the lamps described in JP 2006-279008 A and corresponding US 2006/197454 A1. In the lamps, as shown in Fig. 10 of JP 2006-279008 A and corresponding US 2006/197454 A1, a plurality of filaments are arranged roughly on the same axis along the tube axis direction within one light tube. These filaments are each connected to an individual feed device. The lamp with this configuration will be referred to as a multi-filament lamp hereafter. The heat treatment device of the light irradiation type proposed by the inventors has a light source wherein a plurality of multi-filament lamps is aligned in parallel.

Herein, for each filament in the light source configured such that the plurality of multi-filament lamps are aligned in parallel, as described in JP 2007-157780 A and corresponding US 2007/120227 A1, the length and the number of filaments are determined by corresponding to an irradiation area on the workpiece. For example, in the example shown in Fig. 4 of JP 2007-157780 A and corresponding US 2007/120227 A1, the irradiation area is divided into three zones, a wafer area, a guard ring internal area and a guard ring external area, and length of the plurality of filaments to be arranged within the multi-filament lamps composing the light source is adjusted accordingly. Individual control of the power supplied to each filament arranged as mentioned above enables the light irradiation onto each zone set within the irradiation areas of the workpiece to be fixed to a desired irradiance in each zone, respectively.

### Summary of the Invention

As described above, using the light irradiation type heat treatment device having a light source configured such that a plurality of multi-filament lamps is aligned in parallel enables the realization of zone control with high accuracy. However, as described above, the power supply to the plurality of filaments within the multi-filament lamps is individually controlled. Therefore, basically, as many independent control systems are needed as there are filaments. When the number of the filaments is increased as the workpiece becomes large in size, a large number of control systems is required according to this number. Therefore, the light irradiation type heat treatment device itself becomes massive, and the device costs will be increased.

The present invention has been accomplished according to such circumstances, and the object is to provide a light irradiation type heat treatment device that can prevent the device from becoming massive, even if the number of filaments is increased in association with a workpiece becoming large in size on the occasion of performing light heat treatment of the workpiece using a light irradiation type heat treatment device having a light source composed of a plurality of lamps including multi-filament lamps, and that can prevent the increase in the device cost. In other words, the objective is to provide a light irradiation type heat treatment device that can effectively realize, with a comparatively simple configuration, power supply control to the filaments in each lamp corresponding to each zone set in the light irradiation areas.

As a result of various studies by the inventors of the present invention, in a light irradiation type heat treatment device having a light source composed of a plurality of lamps including multi-filament lamps, it was discovered that even though the number of filaments is increased in association with a workpiece becoming large in size, if the workpiece is divided into zones of specific areas and the filaments corresponding to the specific areas are configured as bundle of groups, respectively, and the control is performed per group, even if the number of control sections is a few, a desired temperature control can be conducted.

Based upon the above-mentioned discovery, in the present invention, the problem is solved as follows:
(1) In a light irradiation type heat treatment device where light from lamp units having a plurality of lamps with lead wires for individually supplying electric power to a plurality of filaments axially aligned within a light tube are arranged in parallel irradiate a workpiece and the workpiece is heated; the filaments within one lamp and filaments in other lamps are put together and form a plurality of groups. Then, drive units for supplying electric power to each filament of the lamps and power control units, which are established for each group, for collectively controlling the drive units for supplying electric power to the filaments of the respective group are established.
(2) In the above-mentioned (1), when a plurality of lamps are aligned in parallel, each filament length within each lamp is set to a length so as to form concentric circles by the filaments, respectively, and the plurality of lamps are arranged in parallel so as to form concentric circles by individual filaments. In addition, the filaments belonging to the same concentric circle are divided into one or a plurality of groups, and a power control unit is established per divided group, and the power control unit collectively controls the drive units for supplying electric power to the filaments belonging to the group, respectively.
(3) In the above-mentioned (1) and (2), sensors for detecting the temperature of areas to be irradiated by the filaments are provided, and the power control units drive the drive unit for supplying electric power to the filaments in each group so as to adjust the temperature detected by the temperature sensors to a predetermined temperature pattern, respectively, and control the temperature in each area.
(4) In the above-mentioned (1) and (2), a predetermined control pattern is set to the power control units, and the power control, based upon the predetermined control pattern, drive the drive units for supplying electric power to the filaments in each group and control each area to be at a desired temperature.

In the present invention, the following effects mentioned below can be obtained.
(1) By setting of zones in the irradiation areas of the workpiece not only in a concentric fashion as in the prior art, but by further dividing the same concentric circle into a plurality of zones and to set the irradiance in each zone at a predetermined value, while the temperature distribution is maintained uniformly with high accuracy throughout the entire wafer surface, it becomes possible to perform the light irradiation heat treatment to a wafer.
(2) Since the filaments within the lamps comprising the lamp unit, which is a light source, are put together and compose a filament group corresponding to each zone and each filament is individually connected to a drive unit for supplying electric power and the drive units are collectively controlled by the same control signal from the power control unit established in each group, supplying power to each filament belonging to the same group can be collectively controlled by one control signal without requiring as many independent control systems as the number of filaments. Consequently, it becomes possible to effectively implement the power supply control to the filaments in each lamp with a comparatively simple configuration.
(3) The voltage to be applied to the filaments belonging to each filament group is individually adjusted based upon a predetermined temperature control pattern and temperature information from the temperature sensors and the temperature in each zone is controlled, and thus, it becomes possible to implement heat treatment including a temperature rising process and a temperature decreasing process to a workpiece while the temperature distribution of the workpiece is roughly evenly maintained. Further, since the temperature information from the temperature sensors is fed back and supplying electric power to each filament group is controlled, it becomes possible to implement temperature control in a heat treatment zone with high accuracy.

### Brief Description of the Drawings

Fig. 1 shows an example of the configuration of a heat treatment device of the light irradiation type of the present invention.

Fig. 2 shows a detailed configuration of a known heater.

Fig. 3 shows an example of zone division in a light irradiation area and an arrangement example of filaments within a multi-filament lamp.

Fig. 4 shows a configuration of the power source in the first embodiment of the present invention.

Fig. 5 shows a detailed configuration of the drive units of the first embodiment.

Fig. 6 shows an example of a heat treatment procedure and a control pattern.

Fig. 7 shows a configuration of the power control units and drive units driving the first filament group in the first embodiment.

Fig. 8 shows a configuration of the power source in a second embodiment of the present invention.

Fig. 9 shows an example where the temperature sensor corresponding to the zone 5 is omitted in the second embodiment.

Fig. 10 shows an example of a configuration of the drive units in the second embodiment.

Fig. 11 shows a configuration of the power control units and the drive units for driving the first filament group in the second embodiment.

Fig. 12 shows an example of a configuration of a conventional light source configured with a plurality of straight tube lamps aligned in parallel.

### Detailed Description of the Invention

Hereafter, embodiments of the present invention will be described.

### A. Overall configuration of the light irradiation type heat treatment device

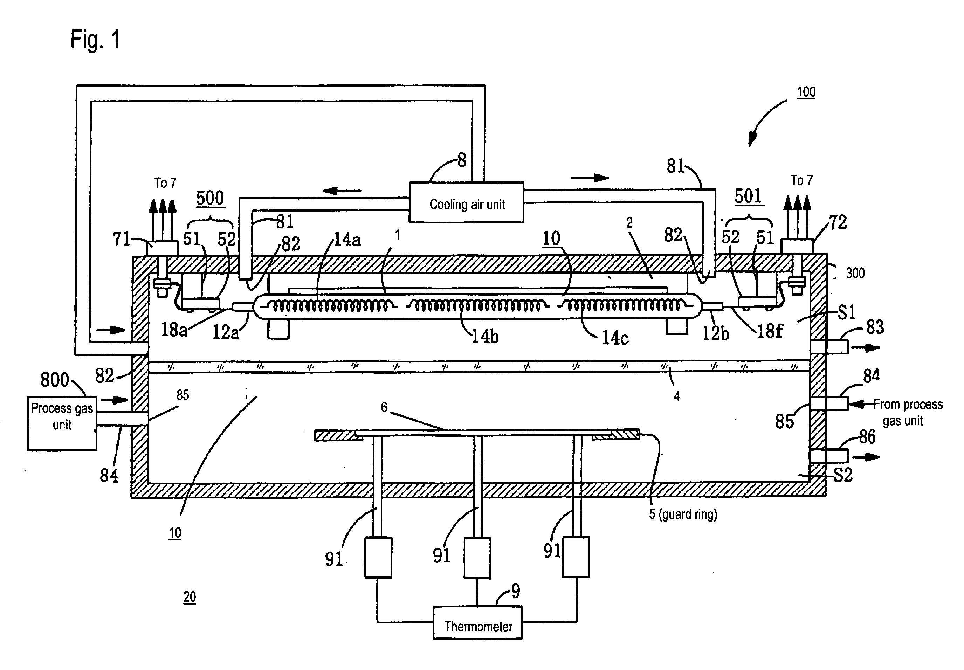

First, an example of a configuration of a heat treatment device 100 of the light irradiation type will be described with reference to Fig. 1.

As shown in Fig. 1, the heat treatment device 100 of the light irradiation type has a chamber 300. The inside of the chamber 300 is divided into a lamp unit accommodation space S 1 and heat treatment space S2 by a quartz window 4. A lamp unit 10 for emitting light is located in the lamp unit accommodation space S1 for irradiating a workpiece 6 placed in the heat treatment space S2 via the quartz window 4 to heat treat the workpiece.

The lamp unit 10, which is a light source accommodated in the lamp unit accommodation space S1, is configured by arranging, for example, eight straight tube incandescent lamps 1 in parallel at predetermined intervals. In the lamp unit 10 of the heating device used for this heating method, the incandescent lamps having a plurality of light emitting parts are aligned in parallel separated by a predetermined distance.

Herein, some incandescent lamps 1 composing the lamp unit 10 are, for example, as described in JP 2006-279008 A and corresponding US 2006/197454 A1, and make up a heater with a configuration where filaments arranged within the straight light tube are divided into a plurality of units where each filament can be independently supplied with power. In other words, each heater of the lamp unit 10 has a straight tube arrangement of an incandescent lamp, and further, has one or more light emitting parts arranged roughly axially. Then, individual light emission of the filament, which is a light emitting part of each heater, and individual adjustment of the power supply to the filament of each heater enable the optional setting of the light intensity distribution on the workpiece 6 with high accuracy.

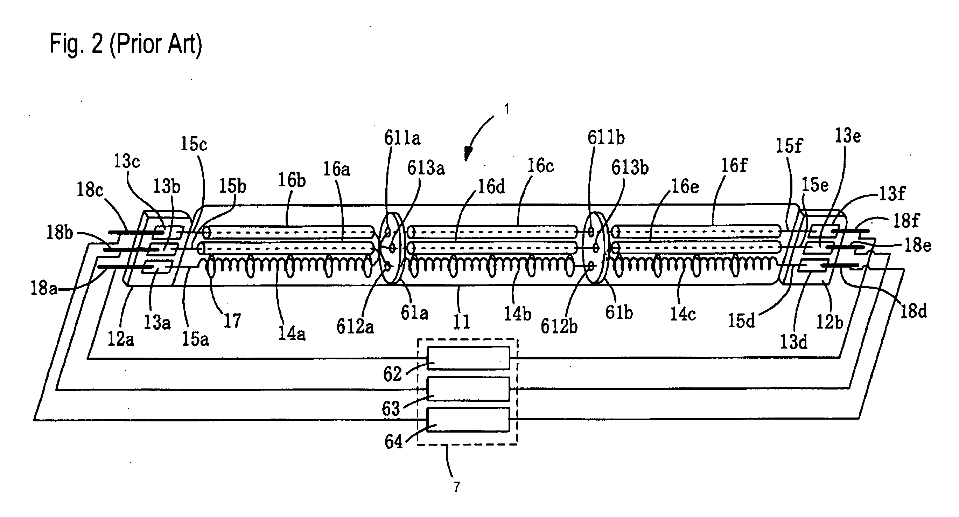

Fig. 2 shows an example of the incandescent lamp 1 (hereafter, referred to as a heater, as well) having three filaments 14a, 14b and 14c. Herein, it is not always necessary to arrange one ore more light emitting parts in each heater 1 roughly on the same axis of the straight tube lamp. However, if it is designed to arrange one or more light emitting parts roughly on the same axis, since it becomes possible to have a straight tube structure in each heater, the arrangement of the heaters in the lamp unit is simple, and it becomes easy to make each heater interval comparatively narrow. In other words, as the structure of incandescent lamp, it is desirable to adopt a structure where the light tube shape corresponds to a straight tube, and power supply devices for each of the filaments are arranged at both ends of the straight tube; in other words, a straight tube double end lamp structure.

Fig. 2 shows a detailed structure of the heater 1 described in JP 2006-279008 A and corresponding US 2006/197454 A1. As shown in Fig. 2, in the light tube 11 of the heater 1, hermetically sealed portions 12a and 12b are formed one end side and the other end side by a pinch seal, respectively, and the inside of the light tube 11 is air-tightly sealed. Herein, the pinch seal is performed so as to bury metal foils 13a, 13b and 13c into the hermetically sealed portion 12a and to bury metal foils 13d, 13e and 13f into the hermetically sealed portion 12b. External leads 18a, 18b, 18c, 18d, 18e and 18f are electrically connected to the metal foils 13a, 13b, 13c, 13d, 13e and 13f, respectively. Three filaments 14a, 14b and 14c are placed within the light tube 11 sequentially roughly along its axis. An insulator 61 a is placed between the filaments 14a, 14b, and an insulator 61b is placed between the filaments 14b, 14c.

A supply wire 15a is electrically connected to one end side of the filament 14a, and the supply wire 15a is further connected to the metal foil 13a. Additionally, a supply wire 15f is electrically connected to the other end side of the filament 14a, and the supply wire 15f is connected to the metal foil 13f. Herein, the supply wire 15f is sequentially placed so as to pass through a through-hole 611a in the insulator 61a, an insulating tube 16c opposing to the filament 14b, a through-hole 611b in the insulator 61b and an insulating tube 16f opposing to the filament 14c.

A supply wire 15b is electrically connected to one end side of the filament 14b, and the supply wire 15b is further connected to the metal foil 13b. Additionally, a supply wire 15e is electrically connected to the other end side of the filament 14b, and the supply wired 15e is connected to the metal foil 13e. Herein, the supply wire 15b is placed so as to pass through a through-hole 612a in the insulator 61a, and an insulating tube 16a opposing to the filament 14a. Further, the supply wire 15e is placed so as to pass through a through-hole 612b in the insulator 61b and an insulating tube 16e opposing to the filament 14c.

A supply wire 15c is electrically connected to one end side of the filament 14c, and the supply wire 15c is further connected to the metal foil 13c. Additionally, a supply wire 15d is electrically connected to the other end side of the filament 14c, and the supply wire 15d is further connected to the metal foil 13d. Herein, the supply wire 15c is placed so as to pass through a through-hole 613b in the insulator 61b, an insulating tube 16d opposing to the filament 14b, a through-hole 613a in the insulator 61a and an insulating tube 16b opposing to the filament 14a. The filaments 14a, 14b, 14c are supported by a plurality of anchors 17 arranged in the axial direction of the light tube 11. The anchors 17 are maintained by being interposed by the inner wall of the light tube 11 and the insulating tube 16a, 16d or 16e.

In the heater 1, a first power supply device 62 is connected between the external leads 18a, 18f, and a second power supply device 63 is connected between the external leads 18b, 18e, and a third power supply device 64 is connected between the external leads 18c, 18d. In other words, the filaments 14a, 14b, 14c are independently fed by the individual power supply devices 62, 63, 64, respectively. The power supply devices 62, 63 and 64 are variable power sources, and the power supply amount is adjustable as occasion demands. Furthermore, each power supply device may supply DC power or AC power to the filaments. Furthermore, details of the power supply device whose power is controllable will be described later.

In other words, according to the heater 1 shown in Fig. 2, three filaments 14a, 14b, 14c are placed in respective order, and since the filaments 14a, 14b, 14c can be independently fed by individual power supply devices 62, 63, 64, respectively, it is possible to individually adjust the quantity of light to be emitted from each filament. Consequently, with the lamp unit having such heater, it becomes possible to set the irradiance on the workpiece 6 as desired and with high accuracy.

Furthermore, the power supply device is not individually established in all filaments included in each heater of the lamp unit 10, respectively, but a plurality of filaments may be connected to one unit of a power supply device according to the desired irradiance.

Hereafter, the plurality of power supply devices may be collectively referred to as a power source 7.

Returning to Fig. 1, a reflecting mirror 2 is arranged at the upper side of the lamp unit 10. The reflecting mirror 2 is, for example, structured such that gold is coated over a base material made of oxygen free copper, and, in a cross-section has a configuration such as a segment of a circle, a part of an ellipse, a part of a parabola or planar shape. The reflecting mirror 2 reflects light irradiated upward from the lamp unit 10. In other words, in the heat treatment device 100 of the light irradiation type, the light emitted from the lamp unit 10 is emitted onto the workpiece 6 directly or via being reflected by the reflecting mirror 2.

Cooling air from a cooling air unit 8 is introduced from an air outlet 82 of a cooling air supply nozzle 81 placed in the chamber 300 into the lamp unit accommodation space S1. The cooling air introduced into the lamp unit accommodation space S1 is directed to each heater 1 in the lamp unit 10 and cools down the light tube 11 comprising each heater 1. Herein, the hermetically sealed portions 12a, 12b of each heater 1 have low heat resistance. Consequently, it is desirable that the outlet 82 of the cooling air supply nozzle 81 is arranged facing against the hermetically sealed portions 12a, 12b of each heater 1 thus cooling the hermetically sealed portions 12a, 12b of each heater 1 on a priority basis. The cooling air that blows down each heater 1, reaches a high temperature due to heat exchange and then is evacuated from a cooling air outlet 83 arranged in the chamber 300. Furthermore, the flow of the cooling air is considered such that the cooling air, which has become hot due to heat exchange, does not inversely heat the heaters 1.

For the cooling air, the air flow is set so as to simultaneously cool the reflecting mirror 2, as well. Furthermore, in the case that the reflecting mirror 2 is cooled with water by a water-cooling mechanism, it is not always necessary to set the air flow to additionally cool the reflecting mirror 2.

Heat storage in the quartz window 4 occurs due to heat radiation from the heated workpiece 6. The workpiece 6 may receive an undesired heating action from heat which is secondarily emitted from the heated quartz window 4. In this case, problems, such as redundancy of temperature controllability of the workpiece (for example, overshoot causing the temperature of the workpiece to become higher than the set temperature) or reduction of temperature uniformity in the workpiece caused by the temperature variance of the quartz window 4, which is itself a heat accumulator, can occur. Further, it becomes difficult to improve the temperature drop rate of the workpiece 6. Therefore, in order to prevent these problems, it is desirable to cool the quartz window 4 by the cooling air from the cooling air unit 8 by placing the air outlet 82 of the cooling air supply nozzle 81 in the vicinity of the quartz window 4 as shown in Fig. 1.

Each heater 1 of the lamp unit 10 is supported by a pair of lamp supports 500, 501. The lamp supports are composed of a conductive base 52 and a holder 51 formed with an insulating material, such as ceramics. Each holder 51 is placed in the inner wall of the chamber 300 and supports the conductive base 52.

When the number of units of the heater comprising the lamp unit 10 is n1 and the number of the divided filaments in the heater is m1, when the power is independently supplied to all filaments, the number of combinations of the pair of the supports 500, 501 is n1 × m1.

A pair of power supply ports 71, 72, where a supply line from the power supply device of the power source 7 is connected, are established in the chamber 300. In Fig. 1, a pair of power supply ports 71, 72 is shown; however, the number of a set of power supply ports is determined according to the number of heaters 1 and the number of filaments within each heater. In the example of Fig. 1, the power supply port 71 is electrically connected to the conductive base 52 of the lamp support 500. The power supply port 72 is electrically connected to the conductive base 52 of the lamp support 501.

The conductive base 52 of the lamp support 500, for example, is electrically connected to the external lead 18a, which is a power supply device of one heater 1 in the lamp unit 10 (see Fig. 2). The conductive base 52 of the lamp support 501 is electrically connected to, for example, an external lead 18f (see Fig. 2). With this configuration, it becomes possible to supply power to the filament 14a of one heater 1 in the lamp unit 10. For the other filaments 14b, 14c of the heater 1, each filament in the other heaters 1 of the lamp unit 10 have a similar electrical connection according to the other pairs of the power supply ports 71, 72.

Also, a treatment table 5 on which the workpiece 6 is fixed, is located in the heat treatment space S2. For example, when the workpiece 6 is a semiconductor wafer, it is preferable that the treatment table 5 is a thin plate annular body made of a high-melting point metal material, such as molybdenum, tungsten or tantalum, or a ceramic material, such as silicon carbide (SiC) or quartz, or silicon (Si), having a guard ring structure where a step part for supporting a semiconductor wafer is formed at the inner periphery of the circular opening of the treatment table 5. The semiconductor wafer 6 is arranged such that the said semiconductor wafer is inserted into the circular opening of the toric treatment table 5 (guard ring), and supported by the aforementioned step part. The treatment table 5 (guard ring) reaches a high temperature due to light irradiation, and an peripheral edge of the facing semiconductor wafer 6 is supplementarily irradiated and heated and heat radiation from the peripheral edge of the semiconductor wafer is compensated. With this design, the temperature reduction at the edge of the semiconductor wafer caused by the heat radiation from the peripheral edge of the semiconductor wafer 6 is prevented.

A temperature measuring unit 91 is established on the rear surface side of the light irradiation surface of the workpiece 6 arranged on the treatment table 5 by coming into contact with the workpiece 6 or in the vicinity of the workpiece 6. The temperature measuring unit 91 is for monitoring the temperature distribution of the workpiece 6, and the number of units and the arrangement are set according to the dimension of the workpiece 6. For the temperature measuring unit 91, for example, a thermocouple or a radiation thermometer is used. The temperature information monitored by the temperature measurement unit 91 is sent to a thermometer 9. The thermometer 9 calculates the temperature at each area, which is a measurement point of each temperature measuring unit 91, based upon the temperature information sent by each temperature measuring unit 91.

Further, a process gas unit 800 for introducing and discharging process gas may be connected to the heat treatment space S2. For example, in the case of a thermal oxidation process, a process gas unit 800 for introducing and discharging oxygen gas, and purge gas (for example, nitrogen gas) for purging the heat treatment space S2 is connected the heat treatment space S2. The process gas and purge gas from the process gas unit 800 are introduced from a supply opening 85 of a gas supply nozzle 84 arranged in the chamber 300 to the heat treatment space S2. Further, the evacuation is conducted from an exhaust outlet 86.

### B. Zone division example in the light irradiation area and arrangement example of filaments corresponding to each zone

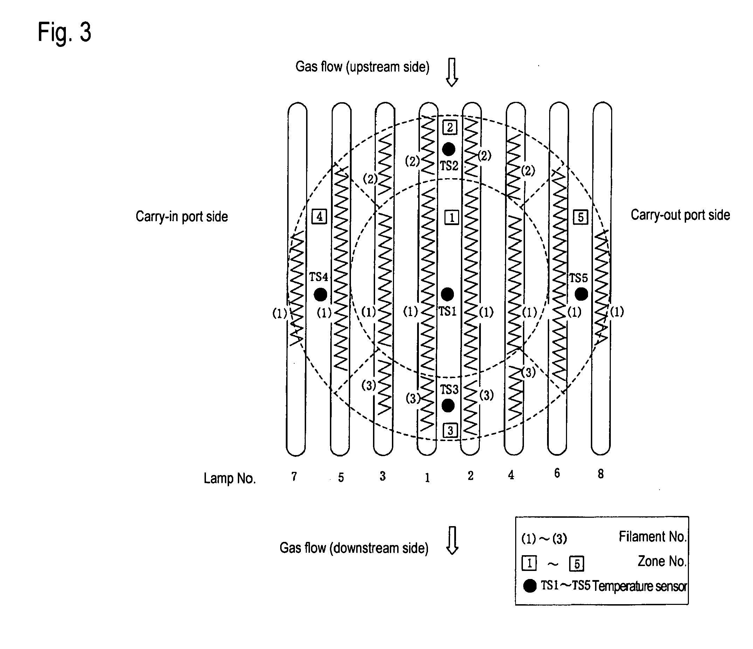

Next, a division example of the zones in the light irradiation area and an arrangement example of the filaments within a multi-filament lamp corresponding to each zone in the case of a heat treatment of a workpiece using the heat treatment device of the light irradiation type of the present invention will be described with reference to Fig. 3.

As an example, a semiconductor wafer is used as the workpiece, and in order to facilitate understanding, the guard ring is not considered.

As described above, in the case that the workpiece is a semiconductor wafer, in the wafer center area and the wafer peripheral area, heating and cooling characteristics at both areas are different from each other because of the effect of the heat radiation from the wafer periphery. Then, as in the conventional case, first, the heat irradiation area on the workpiece is divided into two zones. In other words, a wafer center zone (zone 1) and a wafer peripheral zone are set. Both zones are arranged concentrically, and the inner side is the wafer center zone and outer side is the wafer peripheral zone.

Herein, for example, in the case of performing a thermal oxidation process by light irradiation heat treatment of the workpiece, oxygen gas, which is the process gas, and purge gas (for example, nitrogen gas) for purging the heat treatment space S2 are introduced and evacuated. Other than the thermal oxidation process, in the case that a film is grown on the wafer surface, process gas for film growth is introduced.

As described above, because gas introduction/evacuation is often performed in the heat treatment space S2, the atmosphere within the heat treatment space S2 dynamically fluctuates. As described above, in the heat treatment space 2, in the case that a gas flow of the process gas and purge gas exists, the heating and cooling characteristics in each area shall be different from each other on the surface area of the workpiece positioned at the gas upstream side and on the surface area of the workpiece positioned at the gas downstream side. Under this circumstance, if the light irradiation area on the workpiece is only simply set concentrically, even if the irradiance in each area is adjusted, it is difficult to perform the light irradiation heat treatment to the wafer while the temperature distribution is evenly maintained throughout the entire wafer surface. Such difference in the heating and cooling characteristics between the upstream side and downstream side becomes obvious especially in the wafer peripheral zone.

Further, while not shown in Fig. 1, a carry-in port and a carry-out port for carrying the workpiece in/out the heat treatment space S2 are established in a part of the wall of the heat treatment space S2. Naturally, the surfaces of the carry-in port and the carry-out port are not flat like the normal wall but unevenness exists. When a workpiece placed within the heat treatment space S2 is irradiated with light, with this configuration, a portion of the light from the light source is complicatedly reflected due to the unevenness of the carry-in port and the carry-out port. In other words, there are light-reflecting surfaces where the light reflecting condition does not uniformly exist in the vicinity of the periphery of the wafer. Therefore, the heating and cooling characteristics in the wafer peripheral zone are no longer uniform. In other words, even in the condition where the gas flow is stationary, as similar to gas flows, if the light irradiation area for the workpiece is simply set to be concentric, it is difficult to perform the light irradiation heat treatment of the wafer while the temperature distribution is uniformly maintained throughout the entire wafer surface.
Thus, in order to respond to the effect of the gas flow and the effect of the light-reflecting characteristics on the wall of the heat treatment space S2, the zone setting is further segmented. As described above, the effect of the gas flow and the effect of the light reflecting characteristics on the wall of the heat treatment space S2 act on the wafer peripheral zone. In other words, due to these effects, the heating and cooling characteristics in the wafer peripheral zone become non-uniform. Therefore, the wafer peripheral zone is segmented.

In order to facilitate understanding, in Fig. 3, it is presumed that the process gas and the purge gas flow from the upper side to the lower side relative to the plane of the paper in the figure. Further, the carry-in port and the carry-out port of the workpiece are arranged in the direction perpendicular to the gas flow. In other words, the carry-in port is arranged at the left side of Fig. 3 and the carry-out port is arranged in the right side of Fig. 3. In this configuration, the toric wafer peripheral zone has different heating and cooling characteristics between the gas upstream side and the gas downstream side, and between the vicinity of the carrying-in port and the vicinity of the carrying-out port, respectively. Then, the toric wafer peripheral zone is divided into the zone 2, the zone 3, the zone 4 and the zone 5. In other words, the zone at the gas upstream side, the zone at the gas downstream side, the zone in the vicinity of he carry-in port and the zone in the vicinity of the carry-out port are set as zone 2, zone 3, zone 4 and zone 5, respectively (in Fig. 3, the zones are each surrounded by broken lines, and the zone numbers, 1 to 5, enclosed within a square). As described above, the irradiation area of the workpiece is divided into the zone 1, the zone 2, the zone 3, the zone 4 and the zone 5, and individual adjustment of the irradiance in each zone enables the performance of the light irradiation heat treatment of the wafer while the temperature distribution is uniformly maintained throughout the entire surface of the wafer.

The setting of the length of each filament and arrangement of each filament in the light source composed with a plurality of lamps including multi-filament lamps are determined so as to correspond to the five zones set as mentioned above. In the example shown in Fig. 3, the light source comprises four multi-filament lamps (Nos. 1-4) and four single-filament lamps (Nos. 5-8). The four multi-filament lamps are arranged respectively at the positions corresponding to the central portion of the workpiece and two of the four single-filament lamps are arranged outside the four multi-filament lamps. In other words, the filament (1) of the lamp No. 1, the filament (1) of the lamp No. 2, the filament (1) of the lamp No. 3 arranged outside the lamp No. 1 and the filament (1) of the lamp No. 4 arranged outside the lamp No. 2 are arranged so as to correspond to the zone 1, which is the wafer center zone (the filaments are indicated with the number shown in parentheses in Fig. 3).

Hereafter, in order to simplify the notation, a filament B of lamp No. A shall be referred to as filament A-B. For example, the filament (1) of the lamp No. 1 is referred to as the filament 1-1. In other words, the filaments corresponding to zone 1 are arranged in respective order of the filaments 3-1, 1-1, 2-1 and 4-1 from the left side of Fig. 3. Furthermore, hereafter, in the case of naming these filaments generically, it may be referred to as filament 14. Further, the length of each filament is set so as to correspond to the circular zone 1. In other words, the length of filaments 3-1 and 4-1 is shorter than that of the filaments 1-1 and 2-1.
Similarly, the filaments 3-2, 1-2, 2-2 and 4-2 are arranged in respective order from the left side of Fig. 3 so as to correspond to zone 2 arranged at the gas upstream side. The length of these filaments is set by corresponding to the configuration of the zone 2. Further, the filaments 3-3, 1-3, 2-3 and 4-3 are arranged in respective order from the left side of Fig. 3 so as to correspond to the zone 3 arranged at the gas downstream side. The length of these filaments is set by corresponding to the configuration of the zone 3. In addition, the filaments 7-1 and 5-1 are arranged in respective order from the left side of Fig. 3 so as to correspond to the zone 4 arranged at the carry-in port side. The length of these filaments is set by corresponding to the configuration of the zone 4. In addition, the filaments 6-1 and 8-1 are arranged in respective order from the left side of Fig. 3 so as to correspond to the zone 5 arranged at the carry-out port side. The length of these filaments is set by corresponding to the configuration of the zone 5. In other words, when the lamps are aligned from the left side of Fig. 3, the lamp No. 7, the lamp No. 5, the lamp No. 3, the lamp No. 1, the lamp No. 2, the lamp No. 4, the lamp No. 6 and the lamp No. 8, the length of each filament within each lamp is set as follows: The length of the filaments 3-1, 1-1, 2-1 and 4-1 is set to be length so as to form a circle to correspond to the zone 1 when the lamps are aligned in parallel in respective order. Further, the length of the filaments 3-2, 1-2, 2-2, 4-2, 3-3, 1-3, 2-3, 4-3, 7-1, 5-1, 6-1 and 8-1 is set to be length so as to form a concentric circle to correspond to the wafer peripheral zone (zone 2, zone 3, zone 4 and zone 5).

### C. Configuration of the power source

In the present invention, the filaments 3-1, 1-1, 2-1 and 4-1 corresponding to the zone 1 are configured as a first filament group, and the power supply to each filament belonging to this first filament group is collectively controlled. Similarly, the filaments 3-2, 1-2, 2-2 and 4-2 corresponding to the zone 2 are configured as a second filament group; the filaments 3-3, 1-3, 2-3 and 4-3 corresponding to the zone 3 are configured as a third filament group; the filaments 7-1 and 5-1 corresponding to the zone 4 are configured as a fourth filament group; and the filaments 6-1 and 8-1 corresponding to the zone 5 are configured as a fifth filament group, and the power supply to each filament belonging to each group is collectively controlled, respectively. In other words, each filament corresponding to the wafer peripheral zone, which is the same concentric circle, is divided so as to construct the second, the third, the fourth and the fifth filament group, and the power supply to each filament belonging to each group is collectively controlled, respectively.

Regarding the constructions for collectively controlling the power supply to each filament belonging to the first, second, third, fourth and fifth filament groups, Embodiment 1 and Embodiment 2 will be described in detail with reference to the drawings.

### (a) Embodiment 1

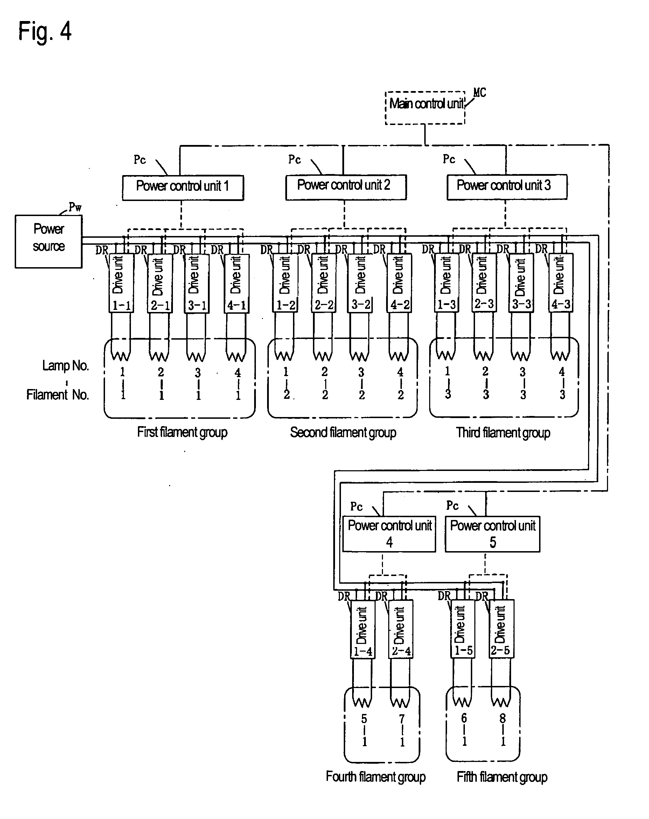

Fig. 4 shows a configuration of the power source in the first embodiment of the present invention. As shown in Fig. 4, the power supply to each filament is provided by the drive units DR1-1 to DR2-5 that are individually connected to each filament. The drive units DR1 to DR2-5 adjust the electric power supplied to each filament from a power source Pw according to a command from a respective one of the power control units Pc1 to Pc5.

In the first filament group corresponding to the zone 1, the power supply to filament 1-1 is conducted by the drive unit DR1-1. Similarly, the power supply to the filaments 2-1, 3-1 and 4-1 is conducted by the drive units DR2-1, DR3-1 and DR4-1, respectively. Herein, the drive unit DR1-1 adjusts the electric power supplied from the power source Pw so as to adjust the light intensity of the light emitted from the filament 1-1 at the power distribution to a predetermined value, and supplies the adjusted electric power to the filament 1-1. Similarly, the drive units DR2-1, DR3-1 and DR4-1 adjust the electric power supplied from the power source Pw so as to adjust the light intensity of the light emitted from the filaments 2-1, 3-1 and 4-1 at the power distribution to a predetermined value, and supply the adjusted electric power to the filaments 2-1, 3-1 and 4-1, respectively. Furthermore, hereafter, generically the drive units are named DR and the power control units generically are referred to as Pc.

Herein, it is necessary to set the irradiance in the zone 1 so as to be roughly uniform with a predetermined value. The light intensity of the light to be emitted from each filament 1-1, 2-1, 3-1 and 4-1 is adjusted to be roughly uniform with a predetermined value so as to have roughly uniform irradiance with a predetermined value in the zone 1. Herein, in order to facilitate understanding, in the zone 1, it is assumed that there is no influence of light emitted from the filaments corresponding to another zone. In this case, it is necessary to adjust the light intensity of the light emitted from the filaments 1-1, 2-1, 3-1 and 4-1 to be roughly the same value. Therefore, the electric power to be supplied to the filaments 1-1, 2-1, 3-1 and 4-1 is adjusted so as to have roughly the same light intensity of the light to be emitted from the filaments 1-1, 2-1, 3-1 and 4-1 with a predetermined value.

The power control unit Pc1 sends a command signal to drive units DR1-1, DR2-1, DR3-1 and DR4-1 so as to achieve roughly uniform irradiance in the zone 1 with a predetermined value. Herein, the command signal to each drive unit is the same signal.

When the command signal is input, the drive units DR1-1, DR2-1, DR3-1 and DR4-1 adjust the electric power to be supplied to the filaments 1-1, 2-1, 3-1 and 4-1 so as to have roughly the same light intensity of the light to be emitted from the filaments 1-1, 2-1, 3-1 and 4-1 with a predetermined value, respectively. Herein, the light intensity of the light to be emitted from the filaments 1-1, 2-1, 3-1 and 4-1 to be adjusted at roughly the same value is a light intensity that results in an irradiance in the zone 1 with the predetermined value. In other words, the actions of the drive units DR1-1, DR2-1, DR3-1 and DR4-1 supplying electric power to the filaments 1-1, 2-1, 3-1 and 4-1 comprising the first filament group corresponding to the zone 1 are collectively controlled by the same command signal from the power control unit Pc1.

Similarly, it is necessary to set the irradiance in the zones 2, 3, 4 and 5 to be roughly the same with a predetermined value, respectively. Therefore, it is necessary to set the light intensity of the light to be emitted from the filaments forming the second filament group corresponding to the zone 2, the filaments forming the third filament group corresponding to the zone 3, the filaments forming the fourth filament group corresponding to the zone 4 and the filaments forming the fifth filament group corresponding to the zone 5 so as to be roughly the same with a predetermined value, respectively, as well. In order to realize this setting, each drive unit corresponding to the second filament group, each drive unit corresponding to the third filament group, each drive unit corresponding to the fourth filament group and each drive unit corresponding to the fifth filament group individually adjust the electric power to be supplied to each filament belonging to each filament group, respectively. Furthermore, as described above, in each zone, it is presumed that there is no influence of light emitted from the filament corresponding to other zones.

Herein, the actions of the drive units DR1-2, DR2-2, DR3-2 and DR4-2 supplying electric power to the filaments 1-2, 2-2, 3-2 and 4-2 comprising the second filament group corresponding to the zone 2 are collectively controlled by the same command signal from the power control unit Pc2. Further, the actions of the drive units DR1-3, DR2-3, DR3-3 and DR4-3 supplying electric power to the filaments 1-3, 2-3, 3-3 and 4-3 comprising the third filament group corresponding to the zone 3 are collectively controlled by the same command signal from the power control unit Pc3. Further, the actions of the drive units DR1-4 and DR2-4 supplying electric power to the filaments 5-1 and 7-1 comprising the fourth filament group corresponding to the zone 2 are collectively controlled by the same command signal from the power control unit Pc4. Further, the actions of the drive units DR1-5 and DR2-5 supplying electric power to the filaments 6-1 and 8-1 comprising the fifth filament group corresponding to the zone 2 are collectively controlled by the same command signal from the power control unit Pc5.

As described above, in the present invention, the filaments within a plurality of lamps comprising the lamp unit, which is a light source, are put together and comprise the filaments groups 1, 2, 3, 4 and 5 corresponding to the zones 1, 2, 3, 4 and 5. In detail, the filaments within one lamp in the lamp unit and the filaments within other lamps are put together and comprise one filament group. Each filament is individually connected to a drive unit for supplying electric power. Herein, the drive unit DR for supplying electric power to each filament belonging to each filament group is collectively controlled by the same control signal from the power control unit Pc established for each filament group.

For example, the action of the drive units DR1-1, DR2-1, DR3-1 and DR4-1 for supplying electric power to the filaments 1-1, 2-1, 3-1 and 4-1 belonging to the same group are collectively controlled by the control signal from the power control unit Pc1 established in the first filament group. Similarly, the action of each drive unit for supplying electric power to each filament belonging to each group is collectively controlled by the control signal from the power control units Pc2, Pc3, Pc4 and Pc5 established in the second, third, fourth and fifth filament groups, respectively. Furthermore, the supply devices 62 to 64 shown in Fig. 2 are equivalent to the power source Pw and the drive unit DR, respectively. Further, the power source 7 is equivalent to the power control unit Pc, the power source Pw and the drive unit DR entirely.

Next, a configuration for collectively controlling the action of each drive unit for supplying electric power to each filament belonging to the filament group corresponding to one zone will be described in detail. Hereafter, the control of the first filament group corresponding to the zone 1 shown in Fig. 3 will be described as an example.

The filaments belonging to the first filament group corresponding to the zone1 are arranged in respective order of the filaments 3-1, 1-1, 2-1 and 4-1 from the left side of Fig. 3. Further, the length of each filament is also set so as to respond to the circular zone 1. In other words, the length of the filaments 3-1 and 4-1 is shorter than that of the filaments 1-1 and 2-1.

As described above, it is necessary to set the light intensity of the light to be emitted from the filaments 3-1, 1-1, 2-1 and 4-1 at the time of power distribution to be roughly uniform so as to have roughly uniform irradiance in the zone 1 with a predetermined value.

In the case of setting the irradiance in the zone 1 at a predetermined value, irradiance (W/cm²), which is radiant energy per unit time and per unit area in the zone 1, is determined. Herein, when an interval (cm) between the lamp bulbs (light tube) is determined, the power per unit length of filament is determined. This power per unit length is referred to as power density (W/cm). The power density (W/cm) is expressed with a product of the irradiance (W/cm²) and the interval (cm) between the lamp bulbs.

The rated power of the filament is expressed with a product of the power density (W/cm) and the length of the filament (cm). When the rated power is consumed at the filament, the irradiance in the zone 1 is set to a predetermined value.

Additionally, a filament is normally formed with a wire of filament wound to a coil with a predetermined winding pitch. The resistance value of the filament is determined from the wire diameter of the filament, the diameter of the coil, and the winding pitch value of the coil. Since the wire diameter of the filament, the diameter of the coil, and the winding pitch value of the coil in each lamp are normally designed to be the same, the resistance value of each filament has a predetermined value, respectively. If the voltage to be applied to the filament is referred to as a rated voltage on the occasion of consuming the rated power by the filament, this rated voltage is determined by the rated power and the resistance value of the filament.

As described above, the length of the filaments 3-1, 1-1, 2-1 and 4-1 belonging to the first filament group is not always the same, the rated power expressed as a product of the power density (W/cm) and the filament length (cm) is not always the same in each filament. Herein, the case where the rated voltage of each filament is set to be the same is considered. As described above, the rated voltage is determined by the rated power and the resistance value of the filament. The rated power of the filaments 3-1, 1-1, 2-1 and 4-1 is different from each other as described above, so it is necessary to set the resistance values of the filaments 3-1, 1-1, 2-1 and 4-1 to a predetermined value in order to set the rated voltage of the filaments 3-1, 1-1, 2-1 and 4-1 to the same value. However, as described above, since the wire diameter of the filament, the diameter of the coil and the winding pitch value of the coil in each lamp are normally designed to be the same, the resistance values of the filaments 3-1, 1-1, 2-1 and 4-1 are fixed to a predetermined constant value, respectively. Therefore, the rated voltage of the filaments cannot be set to be the same. In other words, for each filament with a different length from each other, it is necessary to apply a predetermined rated voltage, respectively. Application of the predetermined rated voltage to the filaments 3-1, 1-1, 2-1 and 4-1 results in the setting of the irradiance at a predetermined value in the zone.

Herein, the power source Pw is generally a commercial power source, and the voltage to be applied to the load by the power source Pw is constant. Therefore, in order to apply the predetermined rated voltage to the filaments 3-1, 1-1, 2-1 and 4-1, respectively, it is necessary to adjust the applied voltage to the filament, which is a load, by the drive unit DR.

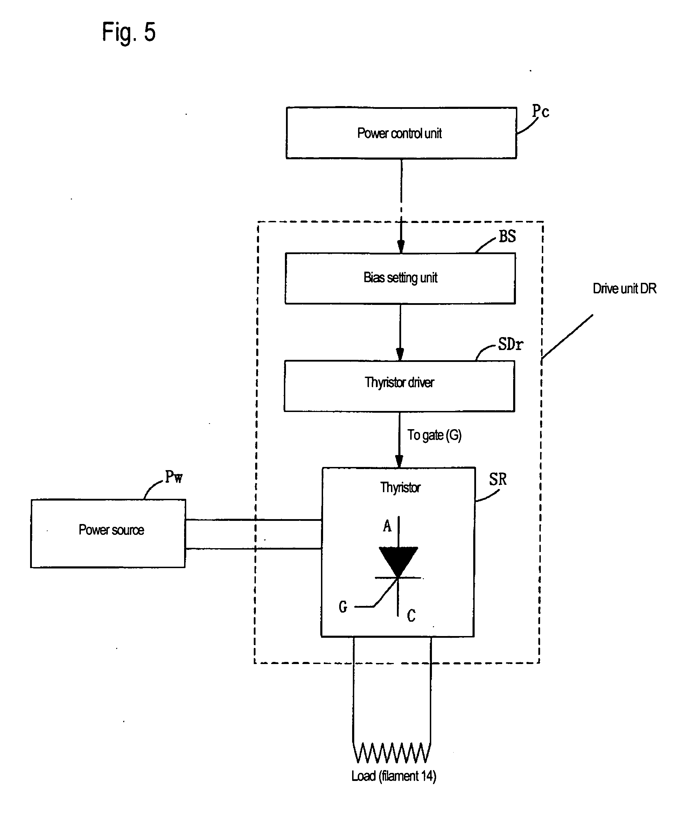

Hereafter, a detailed configuration example of the drive unit will be described using Fig. 5.

Fig. 5 shows the detailed block diagram of the drive unit DR. As shown in Fig. 5, the drive unit DR is composed of a bias setting unit BS, a thyristor driver SDr, and a thyristor SR. The filament 14, which is a load, is connected to the power source Pw via the thyristor SR. In this configuration, the applied voltage to the filament, which is the load, is adjusted by the drive unit DR.

As described above, the power control unit Pc sends a command signal indicating that the irradiance in one zone has a predetermined value and is roughly uniform, to the drive unit DR. For example, the bias setting unit BS of the drive units DR1-1 to DR4-1 sets a bias to the voltage to be applied to the filaments 3-1, 1-1, 2-1 and 4-1, which are loads, from the power source Pw so as to have roughly the same light intensity of the light to be emitted from the filaments 3-1, 1-1, 2-1 and 4-1 based upon the command signal, and it is designed to apply the rated voltage to the filaments 3-1, 1-1, 2-1 and 4-1, respectively.

Herein, as described above, the rated voltage to be applied to each filament is not the same, the setting at the bias setting unit BS in each of the drive units DR1-1 to DR4-1 connected to the filaments is not the same.

Herein, since it is possible for each bias setting unit BS to individually set the bias, it becomes possible to set the rated voltage to be applied to the filaments 3-1, 1-1, 2-1 and 4-1 to be a predetermined value according to the same command signal from the power control unit Pc1, respectively.

When the bias setting unit BS sets the bias, the bias setting unit BS sends a drive signal to the thyristor drive unit SDr. The thyristor drive unit SDr applies a predetermined bias to the voltage to be applied to the load (filament 14) from the power source Pw based upon the drive signal from the bias setting unit BS, and operates the thyristor SR so as to adjust the voltage to be applied to the filament 14 to be the rated voltage. Furthermore, for the bias, for example, a negative value is set. The configuration of the drive unit DR as described above enables the collective control to apply the predetermined rated voltage to the filament 14 according to the same signal from the power control unit Pc, respectively.

Furthermore, in Fig. 5, an example where a thyristor SR is used for the drive unit DR is shown; however, the configuration of the drive unit is not limited to this. For example, a PWM control system using a switching element may be adopted for the drive unit DR.

In this embodiment, the setting of the zones in the irradiation area of the workpiece is not only set to be concentric circles as in the prior art, but the same concentric circle is further divided into a plurality of zones. For this zone setting, not only the effect of the heat radiation from the periphery of the workpiece is considered, but also the effect of the atmosphere in the accommodated space where the workpiece is placed (for example, gas flow, uneven light reflection by a wall in the accommodated space.) Therefore, setting the irradiance in each zone to a predetermined value enables the performance of the light irradiation heat treatment of the wafer while the temperature distribution is uniformly maintained throughout the entire wafer surface with high accuracy.

Further, because supplying electric power to each filament belonging to the same group can be collectively controlled by one control signal without establishing an independent control system according to the number of the filaments, it becomes possible to implement the power supply control to the filaments in each lamp corresponding to each zone set to the light irradiation area efficiently with a comparatively simple configuration. In other words, even if the number of filaments is increased in association with the enlargement of the workpiece, the light irradiation type heat treatment device will not become massive, and it becomes possible to restrain the increase in the device cost.

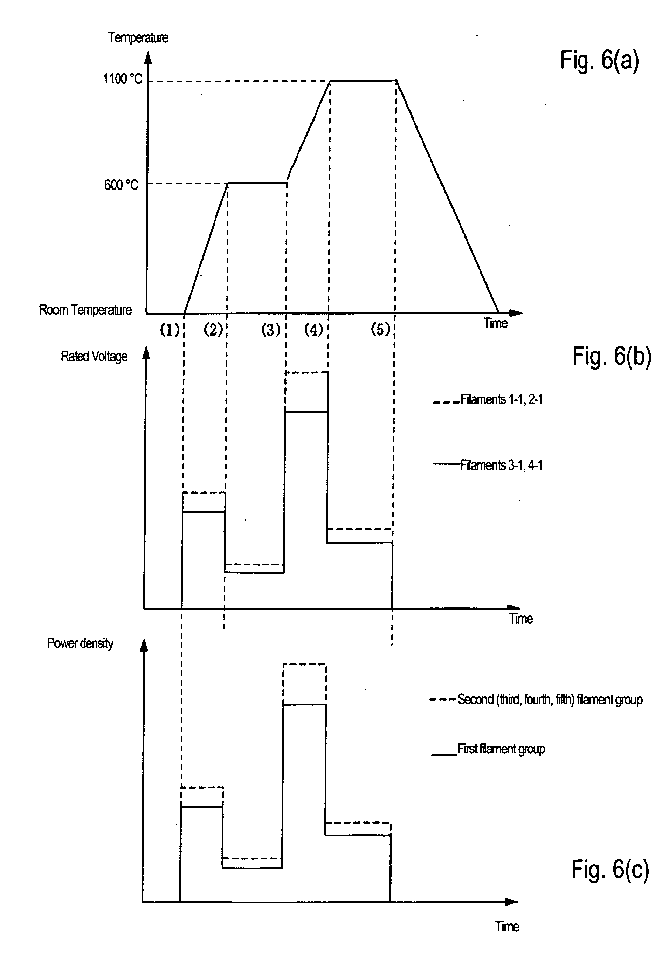

The heat treatment of the workpiece is, for example, conducted with the procedures shown in Fig. 6(a). Herein, a case of heating the workpiece to 1100 °C using a thermal oxidation treatment will be used as an example.

During the period from (1) to (2), the temperature of the workpiece is increased so as to reach 600 °C. After the temperature of the workpiece reaches 600 °C, during the period from (2) to (3), the workpiece is maintained at 600 °C. This is because the action of a plurality of lamps comprising the lamp unit, which is the light source, is stabilized before the heat treatment up to 1100 °C, and the heat treatment atmosphere is stabilized.

After the heat treatment atmosphere is stabilized, during the period from (3) to (4), the workpiece is heated to reach 1100 °C. After the temperature of the workpiece has reached 1100 °C, during the period from (4) to (5), the workpiece is maintained at 1100 °C. Furthermore, the period of time to be maintained at 1100 °C is appropriately set according to a type of heat treatment. Then, after the period (5), the workpiece is cooled down.

In order to realize the heat treatment, each power control unit Pc controls the drive units DR and realizes the lighting control of each filament group. For example, the first power control unit Pc1 controls the power supply to the first filament group as follows.

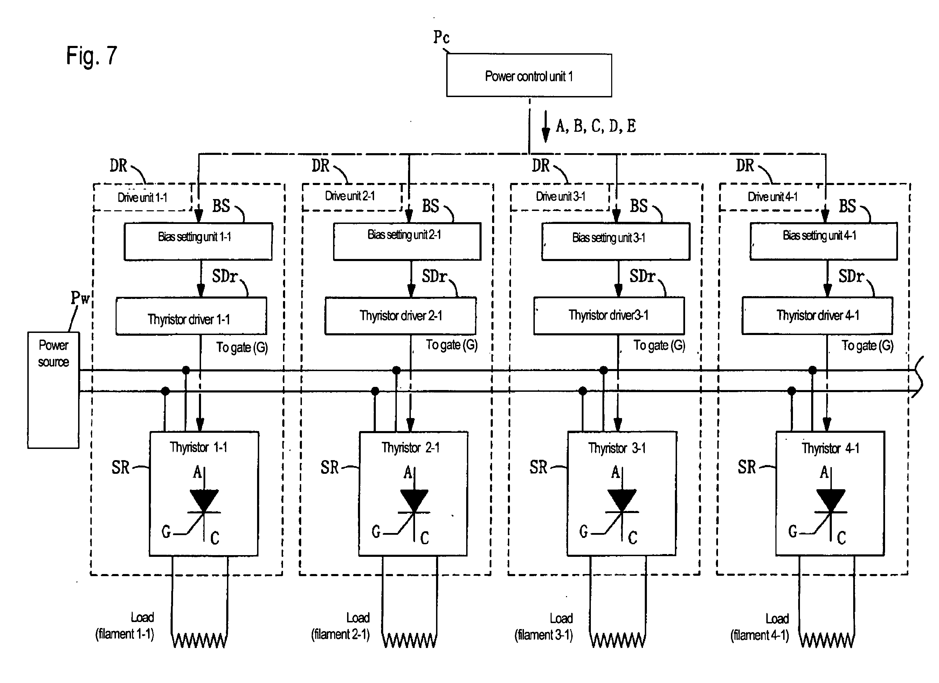

Fig. 7 shows the power control unit and the drive units for driving the first filament group in the first embodiment. Furthermore, hereafter, in order to facilitate understanding, as shown in Fig. 7, it is presumed that the length of the filaments 1-1, 2-1 is the same and the length of the filaments 3-1, 4-1 is the same. Further, the length of the filaments 1-1, 2-1 is longer than that of the filaments 3-1, 4-1.

Light to be emitted from the first filament group irradiates the zone 1, which is the center of the irradiation area of the workpiece (wafer) shown in Fig. 3. The first power control unit Pc1 sends a command signal to adjust the irradiance in the zone 1 to be roughly uniform with a predetermined value to the drive units DR1-1, DR2-1, DR3-1, DR4-1.

As described before, in the case of setting the irradiance in the zone 1 to a predetermined value, the radiation density corresponding to the predetermined irradiance is obtained, and the power density of each filament is obtained from this radiation density and the interval between the bulbs (light tubes) of the lamp. In the case that the bulb interval of the lamps having each filament belonging to the first filament group is equal, the power density to be set to each filament belonging to the first filament group becomes all equal. Then, the rated power of the filaments belonging to the first filament group is set to a predetermined value, respectively, based upon this power density and the length of each filament. In other words, in each filament, if the rated power individually set to each filament is consumed, the irradiance in the zone 1 becomes a predetermined value.

Herein, since the length of the filaments 1-1, 2-1, 3-1, 4-1 comprising the first filament group is not the same, as described above, the rated power of each filament has a relationship as described below. In other words, the rated power of the filaments 1-1, 2-1 is equal and the rated power of the filaments 3-1, 4-1 is equal. In the meantime, because the filament length is longer, the rated power of the filaments 1-1, 2-1 is greater than that of the filaments 3-1 and 4-1. Therefore, the rated voltage of the filaments 1-1, 2-1 is equal, and the rated voltage of the filaments 3-1, 4-1 is equal. In the meantime, because the filament length is longer, the rated voltage of the filaments 1-1, 2-1 is greater than that of the filaments 3-1 and 4-1.

Here, the power source Pw is generally a commercial power source, and the voltage to be applied to the load by the power source is constant. Therefore, as described above, the drive units DR1-1, DR2-1, DR3-1, DR4-1 make adjustment so as to apply the predetermined rated voltage to the filaments 1-1, 2-1, 3-1, 4-1, respectively.

In other words, a bias is individually is set by the bias setting units BS1-1, BS2-1, BS3-1, BS4-1 of the drive units DR1-1, DR2-1, DR3-1, DR4-1, and the bias setting units BS1-1, BS2-1, BS3-1, BS4-1 send a drive signal to the thyristor drive units SDr1-1, SDr2-1, SDr3-1, SDr4-1, respectively. The thyristor drive units SDr1-1, SDr2-1, SDr3-1, SDr4-1 apply a predetermined bias to the voltage to be applied to the filaments 1-1, 2-1, 3-1, 4-1, which are loads, from the power source, based upon the drive signal from the bias setting units BS1-1, BS2-1, BS3-1, BS4-1, and operate the thyristors SR1-1, SR2-1, SR3-1 and SR4-1 so as to adjust the voltage to be applied to the filaments 1-1, 2-1, 3-1, 4-1 at the rated voltage, respectively. It becomes possible to collectively control the voltage so as to apply the predetermined rated voltage to the filaments 1-1, 2-1, 3-1, 4-1 according to the same signal from the power control unit Pc1 by configuring the drive units DR1-1, DR2-1, DR3-1, DR4-1.

A control pattern so as to adjust a relationship between the temperature and the time in zone 1 of the irradiation area of the workpiece as shown in Fig. 6(a) is set to the power control unit Pc1. The power control unit Pc1 controls the drive of the drive units DR1-1, DR2-1, DR3-1, DR4-1 based upon this control pattern. First, the power control unit Pc1 sends a control signal A to the drive units DR1-1, DR2-1, DR3-1, DR4-1 so as to rise the temperature in the zone 1 from room temperature to 600 °C during the temperature rising period from (1) to (2) in Fig. 6 (a) based upon the predetermined control pattern. The drive units DR1-1, DR2-1, DR3-1, DR4-1 that have received the control signal A apply the predetermined rated voltage to the filaments 1-1, 2-1, 3-1, 4-1 based upon the control signal A, respectively. Furthermore, as described above, since the bias is individually set for each of the drive units by the bias setting units, the action of the drive units DR1-1, DR2-1, DR3-1, DR4-1 is collectively controlled by the same control signal from the power control unit Pc1. Further, as shown in Fig. 6(b), the rated voltage to be applied to the filaments 1-1, 2-1 is greater than that to be applied to the filaments 3-1, 4-1 because the filament length is longer.

Next, the power control unit Pc1 sends a control signal B to the drive units DR1-1, DR2-1, DR3-1 and DR4-1 so as to maintain the temperature in the zone 1 during the temperature maintenance period from (2) to (3) in Fig. 6(a) at 600 °C, based upon the predetermined control pattern. The drive units DR1-1, DR2-1, DR3-1, DR4-1 that have received the control signal B apply the predetermined rated voltage to the filaments 1-1, 2-1, 3-1, 4-1 based upon the control signal B, respectively. Here, in the case of maintaining the temperature in the zone 1 at 600 °C, only the thermal radiation from the workpiece (wafer) should be compensated. Therefore, the irradiance in the zone 1 during the temperature maintenance period from (2) to (3) is set at a smaller value than the irradiance in the zone 1 during the temperature rising period from (1) to (2). Therefore, the rated voltage value to be applied to each filament during the temperature maintenance period from (2) to (3) becomes smaller than the value of the rated voltage to be applied to each filament during the temperature rising period from (1) to (2).

Furthermore, similar to the time during the period from (1) to (2), the action of the drive units DR1-1, DR2-1, DR3-1, DR4-1 is collectively controlled by the same control signal B from the power control unit Pc1. Further, it is needless to say, the rated voltage to be applied to the filaments 1-1 and 2-1 is greater than that to be applied to the filaments 3-1 and 4-1 during the temperature maintenance period from (2) to (3) because the filament length is longer.

Next, the power control unit Pc1 sends a control signal C to the drive units DR1-1, DR2-1, DR3-1, DR4-1 so as to increase the temperature to reach 1100 °C in zone 1 during the temperature rising period from (3) to (4) in Fig. 6(a) based upon the predetermined control pattern. The drive units DR1-1, DR2-1, DR3-1, DR4-1 that have received the control signal C apply the predetermined rated voltage to the filaments 1-1, 2-1, 3-1, 4-1 based upon the control signal C. In the case of increasing the temperature in the zone 1 from 600 °C to 1100 °C, as compared to the case of increasing the temperature from room temperature to 600 °C or the case of maintaining at 600 °C, it is necessary to increase the irradiance in the zone 1. In other words, the irradiance in the zone 1 during the temperature rising period from (3) to (4) is set greater than that in the zone 1 during the temperature rising period from (1) to (2) and the temperature maintenance period from (2) to (3). Therefore, the value of the rated voltage to be applied to the filaments during the temperature rising period from (3) to (4) is greater than the value of the rated voltage to be applied to the filaments during the temperature rising period from (1) to (2) and the temperature maintenance period from (2) to (3).

Furthermore, similar to the cases during the temperature rising period from (1) to (2) and the temperature maintenance period from (2) to (3), because the bias is individually set to each of the drive units by the bias setting units, the action of the drive units DR1-1, DR2-1, DR3-1, DR4-1 is collectively controlled by the same control signal C from the power control unit Pc1. Further, it is needless to say, even during the temperature rising period from (3) to (4), the rated voltage to be applied to the filaments 1-1, 2-1 is greater than that to be applied to the filaments 3-1, 4-1 because the filament length is longer.

Next, the power control unit Pc1 sends a control signal D to the drive units DR1-1, DR2-1, DR3-1, DR4-1 so as to maintain the temperature at 1100 °C in the zone 1 during the temperature maintenance period from (4) to (5) in Fig. 6(a) based upon the predetermined control pattern. The drive units DR1-1, DR2-1, DR3-1, DR4-1 that have received the control signal D apply the predetermined rated voltage to the filaments 1-1, 2-1, 3-1, 4-1 based upon the control signal D. Here, in the case of maintaining the temperature in the zone 1 at 1100 °C, only the thermal radiation from the workpiece (wafer) should be compensated. Therefore, the irradiance in the zone 1 during the temperature maintenance period from (4) to (5) is set at a smaller value than the irradiance in the zone 1 during the temperature rising periods from (3) to (4). Therefore, the rated voltage value to be applied to each filament during the temperature maintenance period (4) to (5) becomes smaller than the value of the rated voltage to be applied to each filament during the temperature rising period (3) to (4). Furthermore, the temperature to be maintained during the temperature maintenance period (4) to (5) is 1100 °C, and since this is higher than the temperature 600 °C to be maintained during the temperature maintenance period (2) to (3), the value of the rated voltage to be applied to each filament during the temperature maintenance period (4) to (5) is greater than that to be applied to each filament during the temperature maintenance period (2) to (3).

Further, as similar to during the temperature rising period (1) to (2), during the temperature maintenance period (2) to (3) and during the temperature rising period (3) to (4), because the bias is individually set for each drive unit by the bias setting unit BS, the action of the DR1-1, DR2-1, DR3-1, DR4-1 is collectively controlled according to the same control signal D from the power control unit Pc1. Further, it is needless to say, even during the temperature maintenance period (4) to (5), the rated voltage to be applied to the filaments 1-1, 2-1 is greater than that to be applied to the filaments 3-1, 4-1 because the filament length is longer.

Next, the power control unit Pc1 sends a control signal E to the drive units DR1-1, 2-1, 3-1, 4-1 so as to reduce the temperature in zone 1 based upon the predetermined control pattern after the point of time (5) in Fig. 6(a). The drive units DR1-1, DR2-1, DR3-1, DR4-1 that have received the control signal E stop the application of voltage to the filaments 1-1, 2-1, 3-1, 4-1 based upon the control signal E. As described above, the power control unit 1 sends the control signals A, B, C, D, and E to the drive units DR1-1, DR2-1, DR3-1, DR4-1 for supplying electric power to the filaments 1-1, 2-1, 3-1 and 4-1 belonging to the first filament group based upon the predetermined control pattern, and drive the drive units and adjust the rated voltage to be applied to the filaments and controls the temperature in the zone 1.

The power control unit Pc2, the power control unit Pc3, power control unit Pc4 and power control unit Pc5 similarly control the second, third, fourth and fifth filament group corresponding to the zone 2, the zone 3, the zone 4 and zone 5 shown in Fig. 3. In other words, the power control unit Pc2, the power control unit Pc3, power control unit Pc4 and power control unit Pc5 drive the drive units DR corresponding to the second, third, fourth and fifth filament groups based upon the predetermined control pattern, and control the value of rated voltage to be applied to the filaments belonging to each filament group, and control the temperature in the zone 2, the zone 3, the zone 4 and the zone 5 to be at a predetermined value, respectively. Here, the zone 2, the zone 3, the zone 4 and the zone 5 shown in Fig. 3 are peripheral zones of the workpiece, and it is necessary to compensate the heat radiation from peripheral edge of the workpiece.. Consequently, in order to roughly unify the temperature distribution of the workpiece during the heat treatment, it is necessary to set the irradiance in the zone 2, the zone 3, the zone 4 and the zone 5 at the time of light irradiation to the workpiece to be greater than that in the zone 1, which is the center of the workpiece. For example, in the case of performing the heat treatment shown in Fig. 6(a), the power density to be set to each filament belonging to second, third, fourth and fifth filaments groups during the periods from (1) to (5), as shown in Fig 6(c), is greater than that set by each filament belonging to the first filament group.

Furthermore, Fig. 6(c) shows the case that the power density set to each filament belonging to the second, third, fourth and fifth filament groups is all equal, in order to facilitate understanding. Similarly, a case where it is presumed that the power density set to each filament belonging to the first filament group is all equal is shown. In actuality, as described above, the heating and cooling characteristics in the zone 2, the zone 3, the zone 4 and the zone 5 are different from each other, and the power density set to each filament belonging to the second, third, fourth and fifth filament groups is also different from each other. Further, in the above-mentioned case, in order to facilitate understanding, in the zone 1, it was presumed that there is no influence of the light emitted from the filaments corresponding to the other zones; however, in actuality, the influence of light from the other zones exists in the area close to the zone boundary. Therefore, in the case that the temperature distribution is unified with higher accuracy, it is necessary to set the power density by subtracting the equivalence of the light energy from neighboring filaments corresponding to the other zones for those filaments in the areas where many influences of the light emitted from the filaments corresponding to the other zones exist. In this case, the power density of the filaments belonging to the first filament group shall be different from each other. However, in the zone 2, the zone 3, the zone 4 and the zone 5, because there is the effect of heat radiation from the peripheral edge of the workpiece, the power density set to each filament belonging to the second, third, fourth and fifth filament groups, which are different from each other, is greater than that of the filaments belonging to the first filament group.

As described above, the power control units Pc1, Pc2, Pc3, Pc4 and Pc5 send control signals to the drive units DR for supplying electric power to the filaments belonging to the first, second, third, fourth and fifth filament groups based upon the predetermined control pattern, drive the drive units DR and individually adjust the rated voltage to be applied to the filaments belonging to each filament group, and control the temperature in the zones 1, 2, 3, 4 and 5 during the heat treatment, respectively. This control enables the application of the heat treatment including the temperature increasing process and the temperature decreasing process while the temperature distribution of the workpiece is maintained to be roughly uniform.

### (b) Embodiment 2

In the above-mentioned embodiment, a control pattern corresponding to a heat treatment (for example, Fig. 6(a)) of a workpiece is predetermined to each power control unit Pc. This control pattern is in common to all of the power control units Pc during the periods for the temperature increasing process, temperature maintenance process and temperature decreasing process during a heat treatment. In the meantime, as described above, in order to roughly unify the temperature distribution of the workpiece during the heat treatment, it is necessary to adjust the irradiance in the irradiation area of the workpiece for each zone. Consequently, in the control pattern, a parameter (for example, power density in each filament group) regarding the light intensity to be emitted from the filaments belonging to each filament group is different per power control unit Pc.

Based upon this control pattern, each power control unit Pc controls supplying electric power to the filaments belonging to the filament group relating to said power control unit Pc. For example, each power control unit Pc sends a control signal to the drive units DR and drives the drive units DR, based upon the predetermined control pattern. The drive units DR are to adjust the supplying electric power to each filament belonging to the filament group, and for example, in the above-mentioned example, the drive units DR individually adjust the rated voltage to be applied to each filament. In other words, in the above-mentioned example, the irradiance in each zone is controlled by an open control based upon the control pattern present to each power control unit Pc, and the temperature of the workpiece during the heat treatment is maintained to be roughly uniform.

Further, in the heat treatment device of the light irradiation type of an embodiment to be described hereafter, a temperature sensor is established in each zone. The temperature sensors TS 1 to TS5, for example, as shown in Fig. 3, are established in the center of the zones 1 to 5, respectively. The temperature pattern corresponding to a heat treatment of the workpiece is present to each power control unit Pc. Then, temperature information in each zone from the temperature sensors TS1 to TS5 and the temperature pattern present in each power control unit Pc are compared, and the power control unit Pc controls the drive units DR so as to match the temperature information in each zone with the temperature pattern. In other words, the heat treatment device of the light irradiation type of this embodiment is to control the irradiance in each zone by feedback control for controlling the supply of electric power to each filament group based upon the temperature information in each zone and to maintain the temperature of the workpiece during the heat treatment to be roughly uniform.

Hereafter, this embodiment will be described in detail.

In this embodiment, a semiconductor wafer is used as the workpiece, and the guard ring is not considered in order to facilitate understanding. Further, the light irradiation area on the workpiece is divided into a wafer center zone (zone 1) and ring-shaped wafer peripheral zones (zone 2, zone 3, zone 4 and zone 5). As shown in Fig. 3, temperature sensors for measuring the temperature in each zone are arranged in the zones 1 to 5, respectively. In other words, the temperature sensors TS1, TS2, TS3, TS4 and TS5 are arranged in the zones 1, 2, 3, 4 and 5, respectively.

The supply of electric power to each filament belonging to the filament group corresponding to each zone is performed by the drive units DR individually connected to each filament, similar to the above-mentioned embodiment, respectively. The drive units DR adjust the electric power to be supplied from the power source Pw and supply electric power to each filament according to a command from the power control unit Pc.

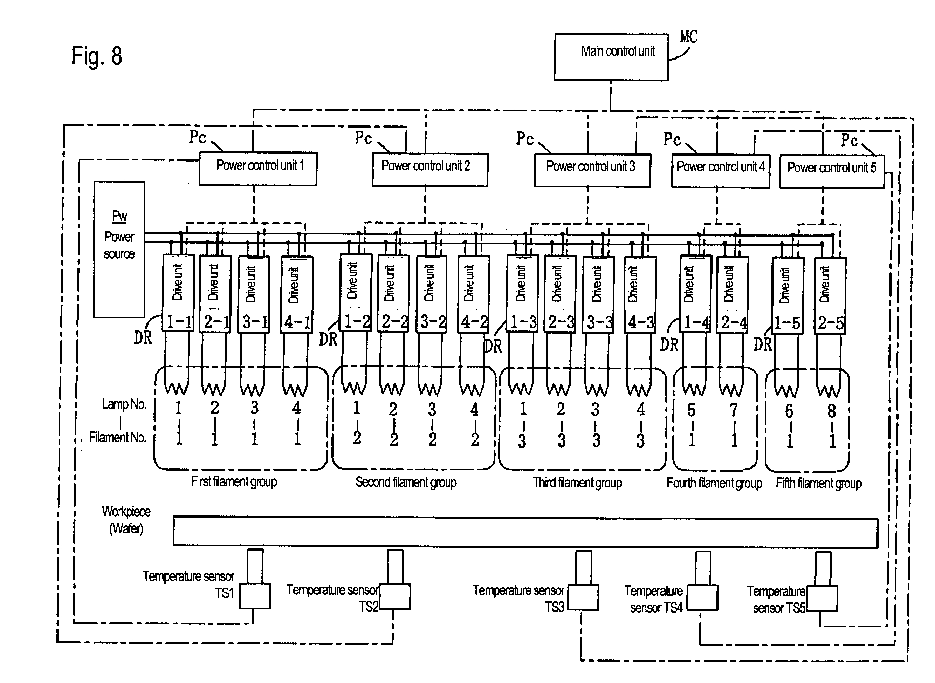

A specific configuration is shown in Fig. 8. Except for the temperature sensors, this diagram shows the same configuration as that in Fig. 4. In other words, in the first filament group corresponding to the zone 1, power supply to the filament 1-1 is delivered by the drive unit DR1-1. Similarly, power supply to the filaments 2-1, 3-1, 4-1 is delivered by the drive units DR2-1, DR3-1, DR4-1, respectively. Herein, the drive unit DR1-1 adjusts the electric power to be supplied from the power source Pw so as to set the light intensity of the light to be emitted from the filament 1-1 at the time of power distribution to a predetermined value based upon a command from the power control unit Pc1, and supplies the adjusted electric power to the filament 1-1. Similarly, the drive units DR2-1, DR3-1, DR4-1 adjust the electric power to be supplied from the power source Pw so as to set the light intensity of light to be emitted from the filaments 2-1, 3-1, 4-1 at the time of power distribution to a predetermined value, and supply the adjusted electric power to the filaments 2-1, 3-1, 4-1.
It is necessary to set the irradiance in the zone 1 to be roughly uniform with a predetermined value. The light intensity of light to be emitted from the filaments 1-1, 2-1, 3-1, 4-1 is adjusted to a predetermined value, respectively, so as to have the irradiance in the zone 1 with a predetermined value. Herein, in order to facilitate understanding, in the zone 1, it is presumed that there is no influence of light emitted from the filaments corresponding to the other zones. In that case, it is necessary to adjust the light intensity of the light to be emitted from the filaments 1-1, 2-1, 3-1 and 4-1 to be roughly the same, respectively. Therefore, the electric power to be supplied to the filaments 1-1, 2-1, 3-1, 4-1 is adjusted so as to have a roughly uniform light intensity of light to be emitted from the filaments 1-1,2-1, 3-1 and 4-1 with a predetermined value.

The power control unit Pc1 sends a command signal so as to adjust the irradiance in the zone 1 to be roughly uniform with a predetermined value to the drive units DR1-1, DR2-1, DR3-1, DR4-1, respectively. Herein, the command signal to each drive unit DR is the same. When the command signal is input, the drive units DR1-1, DR2-1, DR3-1, DR4-1 adjust the electric power to be supplied to the filaments 1-1, 2-1, 3-1, 4-1 so as to have a roughly uniform light intensity of light to be emitted from the filaments 1-1, 2-1, 3-1, 4-1 with a predetermined value, respectively. In other words, the action of the drive units DR1-1, DR2-1, DR3-1, DR4-1 for supplying electric power to the filaments 1-1, 2-1, 3-1, 4-1 comprising the first filament group corresponding to the zone 1 is collectively controlled by the same command signal from the power control unit Pc1, respectively.

Similarly, it is necessary to set the irradiance in the zones 2, 3, 4 and 5 to be roughly uniform with a predetermined value, respectively. Therefore, it is necessary to set the light intensity of light to be emitted from the filaments composing the second filament group corresponding to the zone 2, the filaments composing the third filament group corresponding to the zone 3, the filaments composing the fourth filament group corresponding to the zone 4 and the filaments composing the fifth filament group corresponding to the zone 5 so as to be roughly the same with a predetermined value, respectively,. For realizing this setting, the drive units DR corresponding to the second filament group, the drive units DR corresponding to the third filament group, the drive units DR corresponding to the fourth filament group and the drive units DR corresponding to the fifth filament group individually adjust the electric power of the supplying power to the filaments belonging to each filament group based upon the power control units Pc2, Pc3, Pc4 and Pc5, respectively. Furthermore, as described above, in each zone, it is presumed that there is no influence of light emitted from the filaments corresponding to the other zones.

Herein, the actions of the drive units DR1-2, DR2-2, DR3-2, DR4-2 for supplying electric power to the filaments 1-2, 2-2, 3-2, 4-2 comprising the second filament group corresponding to the zone 2 are collectively controlled by the same command signal from the power control unit Pc2, respectively. Further, the actions of the drive units DR1-3, DR2-3, DR3-3, DR4-3 for supplying electric power to the filaments 1-3, 2-3, 3-3, 4-3 comprising the third filament group corresponding to the zone 3 are collectively controlled by the same command signal from the power control unit Pc3, respectively. Likewise, the actions of the drive units DR1-4, DR2-4 for supplying electric power to the filaments 5-1, 7-1 comprising the fourth filament group corresponding to the zone 4 are collectively controlled by the same command signal from the power control unit Pc4, respectively. Also, the actions of the drive units DR1-5, DR2-5 for supplying electric power to the filaments 6-1, 8-1 comprising the fifth filament group corresponding to the zone 5 are collectively controlled by the same command signal from the power control unit Pc5, respectively.

Herein, the command signal sent from the power control units Pc to the drive units DR is based upon a comparison operation between the temperature information from the temperature sensors TS1 to TS5 placed in each zone and the temperature pattern predetermined in the power control units Pc. In other words, the command signal collectively sent from the power control unit Pc1 to the drive units D1-1, DR2-1, DR3-1, DR4-1 is set according to the comparison operation between the temperature pattern present in the power control unit Pc1 and the temperature information in the zone 1 from the temperature sensor TS1. In detail, the command signal is set so as to minimize the difference between the temperature pattern and the temperature information in the zone 1. The command signal collectively sent to the drive units DR1-2, DR2-2, DR3-2, DR4-2 from the power control unit Pc2 is set according to the comparison operation between the temperature pattern predetermined in the power control unit Pc2 and the temperature information in the zone 2 from the temperature sensor TS2. Similarly, the command signal collectively sent to the drive units DR1-3, DR2-3, DR3-3, DR4-3 from the power control unit Pc3 is set according to the comparison operation between the temperature pattern predetermined in the power control unit Pc3 and the temperature information in the zone 3 from the temperature sensor TS3. The command signal collectively sent to the drive units DR1-4, DR2-4 from the power control unit Pc4 is set according to the comparison operation between the temperature pattern predetermined in the power control unit Pc4 and the temperature information in the zone 4 from the temperature sensor TS4. The command signal collectively sent to the drive units DR1-5, DR2-5 from the power control unit Pc5 is set according to the comparison operation between the temperature pattern predetermined in the power control unit Pc5 and the temperature information in the zone 5 from the temperature sensor TS5.

In the example shown in Fig. 3, the zone at the gas upstream side is set as the zone 2, the zone at the gas downstream side is set as the zone 3, the zone in the vicinity of the carry-in port is set as the zone 4 and the zone in the vicinity of the carry-out port is set as the zone 5. Since the zone 2 and the zone 3 correspond to the gas upstream side and the gas downstream side, the difference between the heating and cooling characteristics in both zones is great. However, in the zone 4 and the zone 5, for example, when the carry-in port structure and the carry-out port structure are the same, there is a case where the difference in the heating and cooling characteristics in both zones becomes negligibly small. In this case, it is unnecessary to establish the temperature sensors TS4, TS5 in the zone 4 and the zone 5, respectively, but it becomes possible to obtain the temperature information in both zones (zone 4 and zone 5) by either one of the temperature sensors.

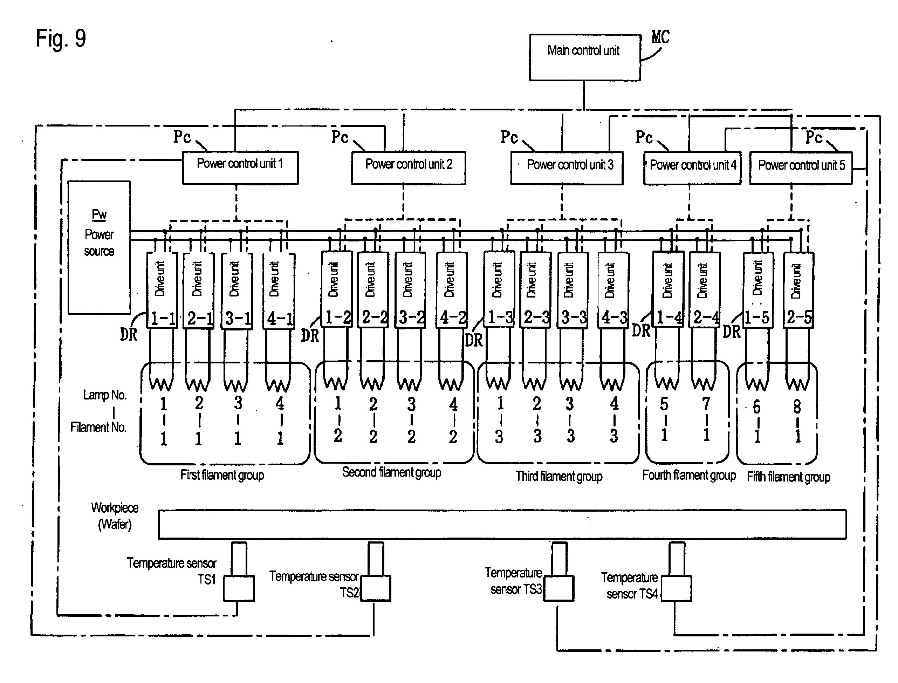

Fig. 9 shows an example where the temperature sensor TS5 corresponding to the zone 5 is omitted. The temperature information from the temperature sensor TS4 corresponding to the zone 4 is sent to both the power control unit Pc4 and the power control unit Pc5. Furthermore, since the other configuration is the same as that shown in Fig. 8, further explanation is omitted.

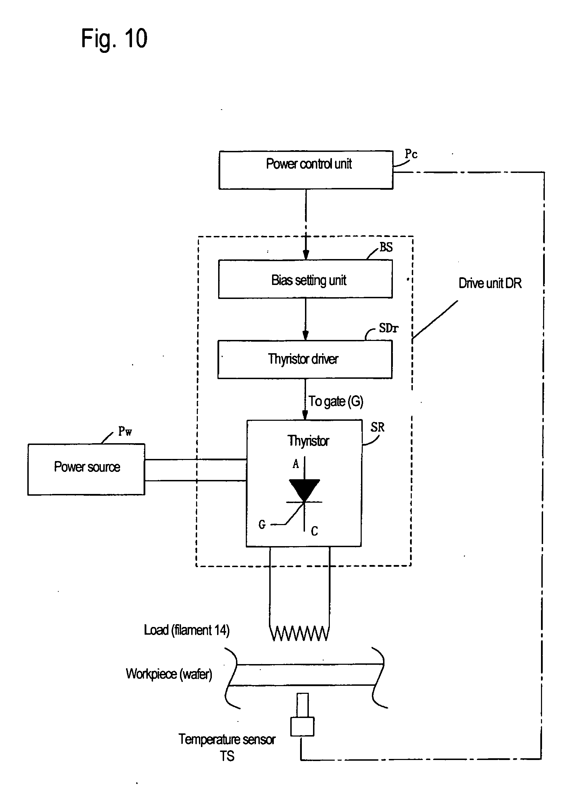

Fig. 10 shows an example of a configuration for collectively controlling the action of each drive unit for supplying electric power to "each filament corresponding to the filament group corresponding to one zone", based upon the temperature information from the temperature sensor. The configuration in Fig. 10 adds the temperature sensors in the configuration in Fig. 5, which has been described. Therefore, a description of the configuration other than the temperature sensors will be omitted.

Hereafter, the zone 1 will be described as an example. As described above, the length of the filaments 3-1, 1-1, 2-1, 4-1 comprising the first filament group is not all the same. The resistance value of the filaments 3-1, 1-1, 2-1, 4-1 is normally fixed to a predetermined constant value, respectively. Therefore, if predetermined rated voltage is applied to each filament with different length from each other respectively, the irradiance in the zone 1 will be set to a predetermined value.

A temperature pattern corresponding to a heat treatment has been stored in the power control unit Pc. Then, the temperature sensor measures the temperature in one zone, and sends the temperature information to the power control unit Pc. The power control unit Pc calculates a command signal so as to minimize the difference between the temperature pattern and the temperature information from the temperature sensor based upon the temperature pattern and the temperature information from the temperature sensor. The power control unit Pc sends a command signal to the drive units DR, and controls the irradiance in one zone to be roughly uniform with a predetermined value. For example, in the case of the zone 1, the power control unit Pc1 compares the predetermined temperature pattern in zone 1 and the temperature information in zone 1 from the temperature sensor TS1 and generates a command signal, and sends the command signal to the drive units D1-1, DR2-1, DR3-1, DR4-1.

The bias setting units BS of the drive units DR set a bias to the voltage to be applied to the filaments 3-1, 1-1, 2-1 and 4-1, which are loads, from the power source Pw so as to roughly unify the light intensity of light to be emitted from a filaments based upon the command signal, and it is designed to apply the rated voltage to the filaments 3-1, 1-1, 2-1, 4-1.

Herein, as described above, since the rated voltage to be applied to each filament is not the same, the setting in the bias setting unit BS of each drive unit DR connected to the filament is also not the same. Since it is possible that the bias setting units BS individually set a bias, it is possible to set the rated voltage to be applied to filaments 3-1, 1-1, 2-1, 4-1 to be a predetermined value according to the same command signal from the power control unit Pc1, respectively. When a bias is set by the bias setting units BS, the bias setting units BS send a drive signal to the thyristor drive units SDr. The thyristor drive units SDr apply a predetermined bias to the voltage to be applied to the load (filament) from the power source Pw based upon thew drive signal from the bias setting unit BS, and operate the thyristors SR so as to adjust the voltage to be applied to the filaments at rated voltage. Furthermore, for the bias, for example, a negative value is set.

The configuration enables the collective feedback control so as to apply a predetermined rated voltage to each filament by the same signal from the power control unit Pc based upon the temperature information in the zone from the temperature sensors TS 1 to TS5. Furthermore, since the configuration is the same for the zones 2, 3, 4 and 5, the description will be omitted.

Furthermore, Fig. 10 shows an example using a thyristor SR for the drive unit DR; however, the configuration of the drive units DR is not limited to this. For example, a PWM control system using a switching element for the drive units may be adopted.

Next, as similar to the above-mentioned embodiment, the heat treatment of a workpiece as shown in Fig. 6(a) is taken as an example, and the heat treatment of a workpiece in the case of the invention in which temperature sensors detect the temperature in each area irradiated by the filaments in the groups and the power control units drive the drive units for supplying power to the filaments in the groups to control the temperature in the respective areas.

In other words, during the period from (1) to (2), a workpiece is heated to reach a temperature of 600 °C, and after the temperature of the workpiece has reached 600 °C, during the period from (2) to (3), the workpiece is maintained at 600 °C. Next, during the period from (3) to (4), the workpiece is heated so as to reach a temperature of 1100 °C, and after the temperature of the workpiece has reached 1100 °C, during the period from (4) to (5), the workpiece is maintained at 1100 °C. Furthermore, the time period to be maintained at 1100 °C is appropriately set according to the type of the heat treatment. Then, at the point of the period (5) and thereafter, the workpiece is cooled down.

In order to realize the above-mentioned heat treatment, the power control unit Pc realizes lighting control of each filament group by controlling the drive units DR. For example, the first power control unit Pc1 controls the power supply to the first filament group with the procedures mentioned below.

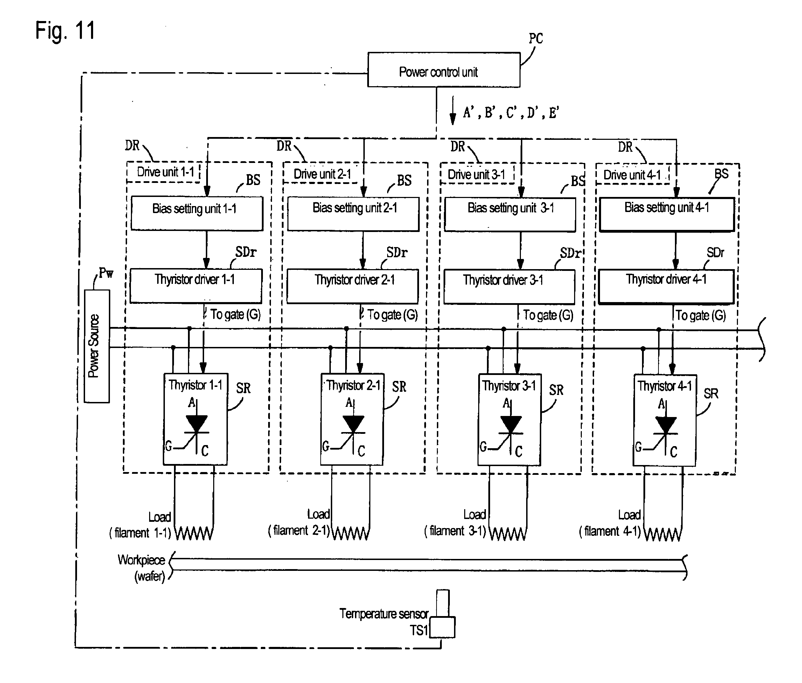

Fig. 11 shows a configuration of the power control unit and the drive units for driving the first filament group, in the second embodiment. Furthermore, in order to facilitate understanding, as shown in Fig. 3, it is presumed that the length of the filaments 1-1, 2-1 is equal, and the length of the filaments 3-1, 4-1 is equal. Further, the length of the filaments 1-1, 2-1 is longer than that of the filaments 3-1, 4-1.

The light emitted from the first filament group irradiates the zone 1, which is a center portion of the irradiation area of the workpiece (wafer) shown in Fig. 3. The first power control unit Pc1 sends a command signal so as to roughly unify the irradiance in the zone 1 with a predetermined value to the drive units DR1-1, DR2-1, DR3-1, DR4-1. As described above, in the case of setting the irradiance in the zone 1 to a predetermined value, a radiation density corresponding to the predetermined irradiance is obtained, and the power density of each filament is obtained from this radiation density and the intervals of the bulbs (light tubes) of the lamp. When the bulb intervals of each filament belonging to the first filament group are equal, the power density set to the filaments belonging to the first filament group become all equal. Then, the rated power of the filaments belonging to the first filament group is set to the predetermined values based upon this power density and the length of each filament, respectively. In other words, in the filaments, when the rated power individually set is consumed, the irradiance in the zone 1 has a predetermined value.

Herein, since the length of the filaments 1-1, 2-1, 3-1, 4-1 comprising the first filament group is different, as described above, the rated power of each filament has the relationship mentioned below. In other words, the rated power of the filaments 1-1, 2-1 is equal, and the rated power of the filaments 3-1, 4-1 is equal. Further, the rated power of the filaments 1-1, 2-1 is greater than that of the filaments 3-1, 4-1 because the filament length is longer. Therefore, the rated voltage of the filaments 1-1, 2-1 is equal, and the rated voltage of the filaments 3-1, 4-1 is equal. In the meantime, because the filament length is longer, the rated voltage of the filaments 1-1, 2-1 is greater than that of the filaments 3-1 and 4-1.

Herein, the power source Pw is generally a commercial power source, and the voltage to be applied to the load by the power source is constant. Therefore, as described above, the drive units DR1-1, DR2-1, DR3-1, DR4-1 adjust the voltage so as to apply the predetermined rated voltage to the filaments 1-1, 2-1, 3-1, 4-1, respectively. In other words, the bias setting units BS1-1, BS2-1, BS3-1, BS4-1 of the drive units DR1-1, DR2-1, DR3-1, DR4-1 individually set a bias, and the bias setting units BS1-1, BS2-1, BS3-1, BS4-1 send a drive signal to the thyristor drive units SDr1-1, SDr2-1, SDr3-1, SDr4-1, respectively. The thyristor drive units SDr1-1, SDr2-1, SDr3-1, SDr4-1 apply a predetermined bias to the voltage to be applied to the filaments 1-1, 2-1, 3-1, 4-1, which are loads, from the power source based upon the bias setting units BS1-1, BS2-1, BS3-1, BS4-1, and operate the thyristors SR1-1, SR2-1, SR3-1, SR4-1 so as to adjust the voltage to be applied to the filaments 1-1, 2-1, 3-1, 4-1 at the rated voltage, respectively. The configuration of the drive units DR1-1, DR2-1, DR3-1, DR4-1 as mentioned above enables the collective control so as to apply the predetermined rated voltage to the filaments 1-1, 2-1, 3-1, 4-1 according to the same signal from the power control unit Pc1, respectively.

A temperature pattern so as to have the relationship between temperature and time in the zone 1 of the irradiation area of the workpiece as shown in Fig. 6(a) is set to the power control unit Pc1. The power control unit Pc1 controls the drive of the drive units DR1-1, DR2-1, DR3-1, DR4-1 based upon this temperature pattern and the temperature information in the zone from the temperature sensor TS 1.

First, the power control unit Pc1 sends a control signal A' to the drive units DR1-1, DR2-1, DR3-1, DR4-1 so as to increase the temperature in the zone 1 during the temperature rising period from (1) to (2) in Fig. 6(a) from room temperature to 600 °C, based upon the predetermined temperature pattern. The drive units DR1-1, DR2-1, DR3-1, DR4-1 that have received the control signal A' apply the predetermined rated voltage to the filaments 1-1, 2-1, 3-1, 4-1, respectively. Furthermore, as described above, because the bias is individually set for each drive unit by the bias setting units BS, the actions of the drive units DR1-1, DR2-1, DR3-1, DR4-1 are collectively controlled according to the same control signal A' from the power control unit Pc1. Further, as shown in Fig. 6(b), the rated voltage applied to the filaments 1-1, 2-1 is greater than the rated voltage applied to the filaments 3-1, 4-1 because the filament length is longer.

Herein, the temperature information in the zone 1 from the temperature sensor TS 1 is input into the power control unit Pc1. The power control unit Pc 1 repeatedly implements comparison operations between this temperature pattern and the temperature information in the zone 1 from the temperature sensor TS1 at predetermined intervals during the temperature rising period from (1) to (2), and the control signal A' is updated based upon the operation result.

Next, the power control unit Pc1 sends a control signal B' to the drive units DR1-1, DR2-1, DR3-1 and DR4-1 so as to maintain the temperature in the zone 1 at 600 °C during the temperature maintenance period from (2) to (3) in Fig. 6(a) based upon the predetermined temperature pattern. The drive units DR1-1, DR2-1, DR3-1, DR4-1 that have received the control signal B' apply the predetermined rated voltage to the filaments 1-1,2-1, 3-1, 4-1 based upon the control signal B'. Herein, in the case of maintaining the temperature in the zone 1 at 600 °C, only the heat radiation from the workpiece (wafer) should be compensated. Therefore, the irradiance in the zone 1 during the temperature maintenance period from (2) to (3) is set at a smaller value than the irradiance in zone 1 during the temperature rising period from (1) to (2). Therefore, the rated voltage value applied to each filament during the temperature maintenance period from (2) to (3) becomes smaller than that to be applied to the filaments during the temperature rising period from (1) to (2).

Furthermore, similar to during the temperature rising period from (1) to (2), the actions of the drive units DR1-1, DR2-1, DR3-1, DR4-1 are collectively controlled according to the same control signal B' from the power control unit Pc1. Further, it is needless to say, the rated voltage applied to the filaments 1-1, 2-1 during the temperature maintenance period from (2) to (3) is greater than that applied to the filaments 3-1, 4-1 because the filament length is longer. Herein, the power control unit Pc1 repeatedly implements comparison operations between the temperature pattern and the temperature information in the zone 1 from the temperature sensor TS 1 at predetermined intervals during the temperature maintenance period from (2) to (3), and updates the control signal B' based upon the operation result.

Next, the power control unit Pc1 sends a control signal C' to the drive units DR1-1, DR2-1, DR3-1, DR4-1 so as to increase the temperature in the zone 1 to reach 1100 °C during the temperature rising periods shown in Fig. 6(a), based upon the predetermined temperature pattern. The drive units DR1-1, DR2-1, DR3-1, DR4-1 that have received the drive signal C' apply the predetermined rated voltage to the filaments 1-1, 2-1, 3-1, 4-1, based upon the control signal C', respectively.

In the case of increasing the temperature in the zone 1 from 600 °C to 1100 °C, compared to the case of increasing the temperature from room temperature to 600 °C or the case of maintaining the temperature at 600 °C, it is necessary to increase the irradiance in the zone. In other words, the irradiance in the zone 1 during the temperature rising period from (3) to (4) is set greater that that in the zone during the temperature rising period from (1) to (2) and during the temperature maintenance period from (2) to (3). Therefore, during the temperature rising period from (3) to (4), the value of the rated voltage applied to the filaments is greater than that of the rated voltage applied to the filaments during the temperature rising period from (1) to (2) and during the temperature maintenance period from (2) to (3).

Furthermore, similar to during the temperature rising period from (1) to (2) and during the temperature maintenance period from (2) to (3), since the bias is individually set for each drive unit by the bias setting units, the actions of the drive units DR1-1, DR2-1, DR3-1, DR4-1 are collectively controlled according to the same control signal C' from the power control unit Pc1. Further, it is needless to say, even during the temperature rising period from (3) to (4), the rated voltage applied to the filaments 1-1, 2-1 is greater than that applied to the filaments 3-1, 4-1 because the filament length is longer. Herein, the power control unit Pc1 repeatedly implements comparison operations between the temperature pattern and the temperature information from the temperature sensor TS1 at predetermined intervals during the temperature rising period from (3) to (4), and updates the control signal C' based upon the operation result.

Next, the power control unit Pc1 sends a control signal D' to the drive units DR1-1, DR2-1, DR3-1, DR4-1 so as to maintain the temperature at 1100 °C in the zone during the temperature maintenance period from (4) to (5) in Fig. 6(a) based upon the present temperature pattern. The drive units DR1-1, DR2-1, DR3-1, DR4-1 that have received the control signal D' apply the predetermined rated voltage to the filaments 1-1, 2-1, 3-1, 4-1 based upon the control signal D'. Herein, in the case of maintaining the temperature in the zone 1 at 1100 °C, only the heat radiation from the workpiece (wafer) should be compensated. Therefore, the irradiance in the zone 1 during the temperature maintenance period from (4) to (5) is set at a smaller value than that in the zone 1 during the temperature rising period from (3) to (4). Therefore, the value of the rated voltage applied to the filaments during the temperature maintenance period from (4) to (5) is smaller than that of the rated voltage applied to the filaments during the temperature rising period from (3) to (4).

Furthermore, the temperature maintained during the temperature maintenance period from (4) to (5) is 1100 °C, and since this is greater than the temperature maintained during the temperature maintenance period from (2) to (3), the value of the rated voltage applied to the filaments during the temperature maintenance period from (4) to (5) is greater than that of the rated voltage applied to the filaments during the temperature maintenance period from (2) to (3). Furthermore, as similar to during the temperature rising period from (1) to (2), during the temperature maintenance period from (2) to (3) and during the temperature rising period from (3) to (4), because the bias is individually set to each drive unit by the bias setting units BS, the actions of the drive units DR1-1, DR2-1, DR3-1, DR4-1 are collectively controlled according to the same control signal D' from the power control unit Pc1. Further, needless to say, even during the temperature maintenance period from (4) to (5), the rated voltage applied to the filaments 1-1 and 2-1 is greater than that applied to the filaments 3-1, 4-1 because the filament length is longer.

Herein, the power control unit Pc1 repeatedly implements comparison operations between the temperature pattern and the temperature information in the zone 1 from the temperature sensor TS1 in predetermined intervals during the temperature maintenance period from (4) to (5), and updates the control signal D' based upon the result.

Next, the power control unit Pc1 sends a control signal E' to the drive units DR1-1, DR2-1, DR3-1, DR4-1 so as to decrease the temperature in the zone 1 after the point (5) in Fig. 6(a) based upon the predetermined control pattern. The drive units DR1-1, DR2-1, DR3-1, DR4-1 that have received the control signal E' stop the application of the voltage to the filaments 1-1, 2-1, 3-1, 4-1 based upon the control signal E'. Since the control signal E' is a signal for instructing to stop the application of the voltage to the filaments 1-1, 2-1, 3-1, 4-1, it is unnecessary to feedback-control the temperature information in the zone 1 from the temperature sensor TS1.

As described above, the power control unit Pc1 sends the control signals A', B', C', D' and E' to the drive units DR1-1, DR2-1, DR3-1, DR4-1 for supplying power to the filaments 1-1, 2-1, 3-1, 4-1 belonging to the first filament group based upon a predetermined temperature pattern and the temperature information in the zone 1 from the temperature sensor TS1, and drive the said drive units and adjust the rated voltage to be applied to the filaments, and control the temperature in the zone 1. Herein, since the control signals A', B', C', D' and E' are updated based upon the temperature information in the zone 1 from the temperature sensor TS1 in predetermined intervals, the temperature control in the zone 1 is highly accurate.

For the second, third, fourth and fifth filament groups corresponding to the zone 2, the zone 3, the zone 4 and the zone 5, the power control unit Pc2, the power control unit Pc3, the power control unit Pc4 and the power control unit Pc5 conduct similar control, respectively. In other words, the power control unit Pc2, the power control unit Pc3, the power control unit Pc4 and the power control unit Pc5 drive the drive units corresponding to the second, third, fourth and fifth filament groups corresponding to the zone 2, the zone 3, the zone 4 and the zone 5 based upon the predetermined temperature pattern and the temperature information of the zones 2, 3, 4 and 5 from the temperature sensors TS2, TS3, TS4, TS5, and control the value of the rated voltage to be applied to the filament belonging to the filament groups, and control the temperature in the zone 2, the zone 3, the zone 4 and the zone 5 to a desired value, respectively.

Herein, the zone 2, the zone 3, the zone 4 and the zone 5 shown in Fig. 3 are peripheral zones of the workpiece, and it is necessary to compensate for the heat radiation from peripheral edge of the workpiece. Consequently, in order to roughly unify the temperature distribution of the workpiece during the heat treatment, it is necessary to set the irradiance in the zone 2, the zone 3, the zone 4 and the zone 5 at the time of light irradiation onto the workpiece to be greater than the irradiance in the zone 1, which is the center of the workpiece.

For example, in the case of the heat treatment as shown in Fig. 6(a), the power density to be set to the filaments belonging to the second, third, fourth and fifth filament groups during the periods from (1) to (5) is greater than that set to the filaments belonging to the first filament group, as shown in Fig. 6(c). Furthermore, Fig. 6(c) shows a case where the power density set to the filaments belonging to the second, third, fourth and fifth filament groups is considered as all equal in order to facilitate understanding. Similarly, the case where the power density set to the filaments belonging to the first filament group is also all equal is shown. In actuality, as described above, since the heating and cooling characteristics in the zone 2, the zone 3, the zone 4 and the zone 5 are different from each other, the irradiances in the zone 2, the zone 3, the zone 4 and the zone 5 are also different from each other, and the power density to be set to the filaments belonging to the second, third, fourth and fifth filament groups is also different from each other. Further, in order to facilitate understanding, in the zone 1, it was presumed that there was no influence of light emitted from the filaments corresponding to the other zones; however, in actuality, influence from the other zone(s) exists in the areas close to the boundary of the zone(s). Therefore, in the case of unifying the temperature distribution with higher accuracy, it is necessary to set the power density by subtracting the equivalence of the light energy from neighboring filaments corresponding to the other zones for those filaments in areas where many influences of light emitted from the filaments corresponding to the other zones exist. In this case, the power density set to the filaments belonging to the first filament group has to be different from each other.

However, in the zone 2, the zone 3, the zone 4 and the zone 5, because there is an effect of heat radiation from the peripheral edge of the workpiece, the power density set to the filaments belonging to the second, third, fourth and fifth filament groups that are different from each other is all greater than that set to the filaments belonging to the first filament group.

As described above, the power control units Pc1, Pc2, Pc3, Pc4, Pc5 send a control signal to the drive units DR for supplying electric power to the filaments belonging to the first, second, third, fourth and fifth filament groups, based upon the predetermined temperature pattern and the temperature information in the zones 1, 2, 3, 4 and 5 from the temperature sensors TS1, TS2, TS3, TS4, TS5, and drive the drive units DR and individually adjust the rated voltage to be applied to the filaments belonging to the first, second, third, fourth and fifth filament groups, and control the temperature in the zones 1, 2, 3, 4 and 5 during the heat treatment, respectively. With such control, while the temperature distribution of the workpiece is maintained roughly uniform, it becomes possible to apply heat treatment including the temperature rising process and the temperature decreasing process to the workpiece. In particular, since the control signals to be sent from the power control units Pc to the drive units DR are regularly updated according to the temperature information in each zone, respectively, it becomes possible to implement the temperature control in the zones 1, 2, 3, 4 and 5 with high accuracy during the heat treatment, respectively.

Furthermore, in the above-mentioned descriptions, as shown in Figs. 4 & 8, a main control unit MC, which is an upper level controller, for controlling the power control units Pc1, Pc2, Pc3, Pc4, Pc5, may be established. The establishment of the main control unit MC enables the overall control of the power control units Pc1, Pc2, Pc3, Pc4, Pc5 by the main control unit MC. For example, in the above-mentioned embodiments, although the control pattern is set to the power control units Pc1, Pc2, Pc3, Pc4 and Pc5, and the power control units Pc control the drive units DR based upon the predetermined control pattern, if a main control unit MC is established as mentioned above, the main control unit MC can send a control pattern to the power control units Pc, and set or change the control pattern, respectively.

## Claims

1. Light irradiation type heat treatment device, comprising:
one or a plurality of lamp units each of which comprises a plurality of lamps arranged in parallel for irradiating a workpiece such that the workpiece is heated, each of the lamps having lead wires arranged for individually supplying power to a plurality of filaments axially aligned within a light tube, the filaments in the lamps together being configured to form a plurality of filament groups;
drive units for supplying power to the filaments in the lamps; and
a power control unit for each filament group for collectively controlling the drive units for supplying power to the filaments of the respective group.

2. The light irradiation type heat treatment device according to claim 1, wherein:
at least one filament within each lamp has a length which forms a concentric circle with filaments of other lamps arranged in parallel; and
the filaments forming the concentric circle are divided into one or a plurality of said filament groups.

3. The light irradiation type heat treatment device according to claim 1 or 2, wherein:
temperature sensors are provided for detecting the temperature in each area irradiated by the filaments of a respective filament group; and
the power control units drive the drive units for supplying power to the filaments in the groups so as to control the temperature in the each area based on the temperature detected.

4. The light irradiation type heat treatment device according to any one of claims 1 to 3, wherein
each of the power control units are set with a respective predetermined control pattern; and
the power control units drive the drive units for supplying power to the filaments in the groups based upon the respective predetermined control pattern.
